(19) Europäisches Patentamt
European Patent Office
Office européen des brevets

(11) EP 2 497 082 B1

(12) EUROPÄISCHE PATENTSCHRIFT

(45) Veröffentlichungstag und Bekanntmachung des Hinweises auf die Patenterteilung:
**04.09.2013 Patentblatt 2013/36**

(21) Anmeldenummer: **10771479.2**

(22) Anmeldetag: **02.11.2010**

(51) Int Cl.:
***G11B 7/24044*** (2013.01)

(86) Internationale Anmeldenummer:
**PCT/EP2010/066591**

(87) Internationale Veröffentlichungsnummer:
**WO 2011/054795 (12.05.2011 Gazette 2011/19)**

# (54) FLUORURETHANE ALS ADDITIVE IN EINER PHOTOPOLYMER-FORMULIERUNG

Fluorurethane as additive in a photopolymer formulation

Fluoruréthane comme additif dans une formule de photopolymères

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.11.2009 EP 09013770**

(43) Veröffentlichungstag der Anmeldung:
**12.09.2012 Patentblatt 2012/37**

(73) Patentinhaber: **Bayer Intellectual Property GmbH**
**40789 Monheim (DE)**

(72) Erfinder:
- **RÖLLE, Thomas**
**51381 Leverkusen (DE)**
- **BRUDER, Friedrich-Karl**
**47802 Krefeld (DE)**
- **FÄCKE, Thomas**
**51375 Leverkusen (DE)**
- **WEISER, Marc-Stephan**
**51379 Leverkusen (DE)**
- **HÖNEL, Dennis**
**53909 Zülpich-Wichterich (DE)**

(74) Vertreter: **BIP Patents**
**c/o Bayer Intellectual Property GmbH**
**Creative Campus Monheim**
**Alfred-Nobel-Straße 10**
**40789 Monheim (DE)**

(56) Entgegenhaltungen:
**WO-A-03/023519**
**WO-A-2008/125229**
**KR-B1- 100 850 022**
**US-A1- 2003 105 263**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 497 082 B1

## Beschreibung

Die Erfindung betrifft eine Photopolymer-Formulierung umfassend Matrixpolymere, Schreibmomomere und Photoinitiatoren, die Verwendung der Photopolymer-Formulierung zur Herstellung von optischen Elementen, insbesondere zur Herstellung von holographischen Elementen und Bildern, ein Verfahren zur Belichtung von holographischen Medien aus der Photopolymer-Formulierung sowie spezielle Fluorurethane.

In der WO 2008/125229 A1 sind Photopolymer-Formulierungen der eingangs genannten Art beschrieben. Diese umfassen Polyurethan-basierte Matrixpolymere, Schreibmomomere auf Acrylbasis sowie Photointiatoren. Im ausgehärtetem Zustand sind in der Polyurethanmatrix die Schreibmonomere und die Photoinitiatoren räumlich verteilt eingebettet. Aus der WO-Schrift ist ebenfalls bekannt Dibutylphthalat, einen klassischen Weichmacher für technische Kunststoffe, der Photopolymer-Formulierung hinzuzufügen.

Für die Verwendungen von Photopolymer-Formulierungen in den unten beschriebenen Anwendungsfeldern spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebenen Wellen) durch die lokale Photopolymerisation von z.B. hochbrechenden Acrylate an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruieren Signals im Verhältnis zur Stärke des eingestrahlten Referenzlichts wird Beugungseffizienz genannt, im folgenden DE wie Diffraction Efficiency. Im einfachsten Fall eines Hologramms, das aus der Überlagerung zweier ebener Wellen entsteht ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die notwendige Lichtmenge des Referenzlichtes die notwendig ist um das Signal mit einer festen Helligkeit sichtbar zu machen. Hochbrechende Acrylate sind in der Lage, Brechungsindexgitter mit hoher Amplitude zwischen Bereichen mit niedrigstem Brechungsindex und Bereichen mit höchstem Brechungsindex zu erzeugen und damit in Photopolymer-Formulierungen Hologramme mit hohem DE und hohem $\Delta n$ zu ermöglichen. Dabei ist zu beachten das DE vom Produkt aus $\Delta n$ und der Photopolymersclichtdicke d abhängt. Je größer das Produkt desto größer die mögliche DE (für Reflexionshologramme). Der Breite des Winkelbereiches bei dem das Hologramm z.B. bei monochromatischer Beleuchtung sichtbar wird (rekonstruiert) hängt nur von der Schichtdicke d ab. Bei Beleuchtung der Hologramms mit z.B. weißem Licht hängt die Breite des spektralen Bereiches der zur Rekonstruktion des Hologramms beitragen kann ebenfalls nur von der Schichtdicke d ab. Dabei gilt je kleiner d desto größer die jeweiligen Akzeptanzbreiten. Will man daher helle und leicht sichtbare Hologramme herstellen ist ein hohes $\Delta n \cdot d$ und eine geringe Dicke d anzustreben und zwar so das DE möglichst groß wird. Das heißt je höher $\Delta n$ wird, desto mehr Freiraum zur Gestaltung heller Hologramme durch Anpassen von d und ohne Verlust an DE erreicht man. Daher kommt der Optimierung von $\Delta n$ bei der Optimierung von Photopolymerformulierungen eine herausragenden Bedeutung zu (P. Hariharan, Optical Holography, 2nd Edition, Cambridge University Press, 1996.).

Aufgabe der vorliegenden Erfindung war es eine Photopolymer-Formulierung bereit zu stellen, die im Vergleich mit den bekannten Formulierungen die Herstellung von Hologrammen mit höherer Helligkeit ermöglicht.

Diese Aufgabe wird bei der erfindungsgemäßen Photopolymer-Formulierung dadurch gelöst, dass sie als Weichmacher Fluorurethane enthält. So wurde gefunden, dass das Hinzufügen von Fluorurethanen zu den bekannten Photopolymer-Formulierungen bei den hieraus hergestellten Hologrammen zu hohen $\Delta n$Werten führt. Im Ergebnis bedeutet dies, dass die aus der erfindungsgemäßen Formulierung hergestellten Hologramme eine im Vergleich zu den bekannten Hologrammen höhere Helligkeit aufweisen.

Bei den Fluorurethanen handelt es sich vorzugsweise um Verbindungen, die ein Strukturelement der allgemeinen Formel (I) aufweisen

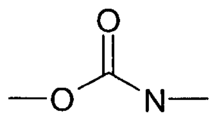 (I)

und mit wenigstens einem Fluoratom substituiert sind.

Weiter bevorzugt ist, wenn die Fluorunethane die allgemeine Formel (II)

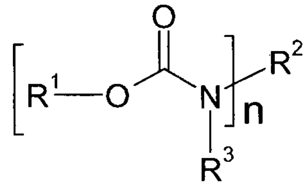

(II)

aufweisen, in der n≥1 und n≤8 ist und $R^1$, $R^2$, $R^3$ Wasserstoff und / oder unabhängig voneinander lineare, verzweigte, cyclische oder heterocyclische unsubstituierte oder gegebenenfalls auch mit Heteroatomen substituierte organische Reste sind, wobei mindestens einer der Reste $R^1$, $R^2$, $R^3$ mit wenigstens einem Fluoratom substituiert ist. Besonders bevorzugt ist hierbei $R^1$ ein organischer Rest mit mindestens einem Fluoratom.

Gemäß einer weiteren Ausführungsform kann $R^1$ 1-20 $CF_2$ Gruppen und / oder eine oder mehrere $CF_3$ Gruppen, besonders bevorzugt 1-15 $CF_2$ Gruppen und / oder eine oder mehrere $CF_3$ Gruppen, insbesondere bevorzugt 1-10 $CF_2$ Gruppen und / oder eine oder mehrere $CF_3$ Gruppen, ganz besonders bevorzugt 1-8 $CF_2$ Gruppen und / oder eine oder mehrere $CF_3$ Gruppen, $R^2$ einen C1-C20 Alkyl-Rest, bevorzugt einen C1-C15 Alkyl-Rest besonders bevorzugt einen C1-C10 Alkyl-Rest oder Wasserstoff, und / oder $R^3$ einen C1-C20 Alkyl-Rest, bevorzugt einen C1-C15 Alkyl-Rest besonders bevorzugt einen C1-C10 Alkyl-Rest oder Wasserstoff umfassen.

Besonders bevorzugt ist, wenn die Fluorurethane Uretdion-, Isocyanurat-, Biuret-, Allophanat-, Polyharnstoff-, Oxadiazadion- und / oder Iminooxadiazindion-Strukturelemente und / oder Mischungen dieser Strukturelemenete aufweisen.

Die Fluorurethane können insbesondere einen Brechungsindex $n_D^{20}$ von ≤ 1.4600, bevorzugt von ≤ 1.4500, besonders bevorzugt von ≤ 1.4400 und insbesondere bevorzugt von ≤ 1.4300 aufweisen.

Die Fluorurethane können einen Fluorgehalt von 10-80 Gew.-% Fluor, bevorzugt von 12.5-75 Gew.% Fluor, besonders bevorzugt von 15-70 Gew.-% Fluor und insbesondere bevorzugt 17.5-65 Gew.-% Fluor aufweisen.

Die Fluorurethane der Formel (III) sind durch Umsetzung von Isocyanaten der Formel $R[NCO]_n$ mit fluorierten Alkoholen in stöchiometrischem Verhältnis zueinander unter Urethanbildung erhältlich.

Bevorzugte Isocyanate der Formel $R[NCO]_n$ sind Methylisocyanat, Ethylisocyanat, die isomeren Propylisocyanate, die isomeren Butylisocyanate, die isomeren Pentylisocyanate, die isomeren Hexylisocyanate, die isomeren Heptylisocyanate, die isomeren Octylisocyanate, die isomeren Nonylisocyanate, die isomeren Decylisocyanate, Stearylisocyanat, Cyclopropylisocyanat, Cyclobutylisocyanat, Cyclopentylisocyanat, Cyclohexylisocyanat, Cycloheptylisocyanat, 2-Methylpentan-1,5-diisocyanat (MPDI), Dodecamethylene-diisocyanat, 1,8-Diisocyanato-4-(isocyanatomethyl)octan (TIN), 6-Diisocyanatohexan (HDI, Desmodur H), 1-Isocyanato-3,3,5-trimethyl-5-isocyanatomethyl-cyclohexan (IPDI, Desmodur I), 2,4,4-Trimethylhexane-1,6-diisocyanat (TMDI), Dicyclohexylmethan-diisocyanat (Desmodur W), Hexahydrotoluylendiisocyanat (H6TDI), Bis(4-isocyanatocyclohexyl)-methan (H12-MDI), 1,3-Bis-(isocyanatomethyl)-cyclohexan, Desmodur LD, Desmodur N 100, Desmodur N3200, Desmodur N3300, Desmodur N3350, Desmodur N3368, Desmodur N3375, Desmodur N3390, Desmodur N3400, Desmodur N3600, Desmodur N3790, Desmodur N3800, Desmodur N3900, Desmodur N50, Desmodur N75, Desmodur NZ1, Desmodur PL340, Desmodur PL350, Desmodur PM76, Desmodur BL3175, Desmodur BL3272, Desmodur BL3370, Desmodur BL3475, Desmodur BL4265, Desmodur BL5375, Desmodur BLXP2677, Desmodur DA-L, Desmodur DN, Desmodur E 305, Desmodur E3265, Desmodur E3370, Baymicron OXA, Desmodur VP LS 2078/2, Desmodur VP LS 2114/1, Desmodur VP LS 2257, Desmodur VP LS 2352/1, Desmodur VP LS 2371, Desmodur VP LS 2376/1, Desmodur XP 2406, Desmodur XP 2489, Desmodur XP 2565, Desmodur XP 2580, Desmodur XP 2599, Desmodur XP 2617, Desmodur XP 2626, Desmodur XP 2675, Desmodur XP 2679, Desmodur XP 2714, Desmodur XP 2730, Desmodur XP 2731, Desmodur XP 2742, Desmodur XP 2748, Desmodur Z 4470 oder deren Mischungen.

Besonders bevorzugte Isocyanate der Formel $R[NCO]_n$ sind isomeren Propylisocyanate, die isomeren Butylisocyanate, die isomeren Pentylisocyanate, die isomeren Hexylisocyanate, die isomeren Heptylisocyanate, die isomeren Octylisocyanate, die isomeren Nonylisocyanate, die isomeren Decylisocyanate, Stearylisocyanat, 1,8-Diisocyanato-4-(isocyanatomethyl)octan (TIN), 6-Diisocyanatohexan (HDI, Desmodur H), 1-Isocyanato-3,3,5-trimethyl-5-isocyanatomethyl-cyclohexan (IPDI, Desmodur I), 2,4,4Trimethylhexane-1,6-diisocyanat (TMDI), Dicyclohexylmethan-diisocyanat (Desmodur W), Hexahydrotoluylendiisocyanat (H6TDI), 1,3-Bis-(isocyanatomethyl)-cyclohexan, Desmodur LD, Desmodur N3400, Desmodur N3600, Baymicron OXA oder deren Mischungen.

Ganz besonders bevorzugte Isocyanate der Formel $R[NCO]_n$ sind iso-Propylisocyanat, n-Butylisocyanat, n-Hexylisocyanat, n-Octylisocyanat, n-Decylisocyanat, Cyclohexylisocyanat, Stearylisocyanat, 1,8-Diisocyanato-4-(isocyanatomethyl)octan (TIN), 6-Diisocyanatohexan (HDI, Desmodur H), 1-Isocyanato-3,3,5-trimethyl-5-isocyanatomethyl-cyclohexan (IPDI, Des modur I), 2,4,4-Trimethylhexan-1,6-diisocyanat (TMDI), Dicyclohexylmethan-diisocyanat (Desmodur W), Hexahydrotoluylendiisocyanat (H6TDI), 1,3-Bis-(isocyanatomethyl)-cyclohexan, Desmodur LD, Desmodur

N3400, Desmodur N3600, Desmodur N3900, Baymicron OXA oder deren Mischungen.

Die Auswahl der fluorierten Alkohole ist dabei breit möglich, es ist bevorzugt, primäre oder sekundäre, mono-, di-, oder trifunktionelle Alkohole mit einem Fluorgehalt von 30 % bis 82 % Fluor, besonders bevorzugt mit einem Fluorgehalt von 40 % bis 80 % Fluor und insbesondere bevorzugt mit einem Fluorgehalt von 49 % bis 75 % Fluor zu verwenden.

Bei der Umsetzung von Isocyanaten mit Alkoholen der jeweils vorstehend genannten Art zur Herstellung der Fluorurethane handelt es sich um eine Urethanisierung. Die Umsetzung kann unter zu Hilfenahme der zur Beschleunigung von Isocyanatadditionsreaktionen bekannten Katalysatoren, wie z.B. tertiärer Amine, Zinn-, Zink-, Eisen- oder Bismuthverbindungen, insbesondere Triethylamin, 1,4-Diazabicycl[2,2,2]-octan, Bismuthoctoat, Zinkoctoat oder Dibutylzinndilaurat erfolgten, die mit vorgelegt oder später zudosiert werden können.

Die Fluorurethane können einen Gehalt an Isocyanatgruppen (M = 42 g/mol) oder freien Isocyanatrestmonomeren von unter 0.5 Gew.-%, bevorzugt von unter 0.2 Gew.-%, besonders bevorzugt von unter 0.1 Gew.-% aufweisen.

Weiterhin können die Fluorurethane Gehalte an nicht umgesetzten hydroxyfunktionellen Verbindungen von unter 1 Gew.-%, bevorzugt von unter 0.5 Gew.-% und besonders bevorzugt von unter 0.2 Gew.-% aufweisen.

Die Fluorurethane können einen Fluorgehalt von 10-80 Gew.-% Fluor, bevorzugt von 12.5-75 Gew.-% Fluor, besonders bevorzugt von 15-70 Gew.-% Fluor und insbesondere bevorzugt von 17.5-65 Gew.-% Fluor aufweisen.

Die Fluorurethane weisen einen Brechungsindex $n_D^{20}$ von ≤ 1.4600, bevorzugt von ≤ 1.4500, besonders bevorzugt von ≤ 1.4400 und insbesondere bevorzugt von ≤ 1.4300 aufweisen auf.

Bei der Herstellung der Fluorurethane können die Isocyanate und die Alkohole jeweils in einem nicht-reaktiven Lösungsmittel, beispielsweise einem aromatischen oder aliphatischen Kohlenwasserstoff oder einem aromatischen oder aliphatischen halogenierten Kohlenwasserstoff oder einem Lacklösungsmittel wie z.B. Ethylacetat oder Butylacetat oder Aceton oder Butanon oder einem Ether wie Tetrahydrofuran oder tert.-Butylmethylether oder einem dipolar-aprotischen Lösungsmittel wie Dimethylsufoxid oder N-Methylpyrrolidon oder N-Ethylpyrrolidon gelöst werden und in dem Fachmann geläufiger Weise vorgelegt oder zudosiert werden.

Nach Reaktionsende können die nicht-reaktiven Lösungsmittel unter Normaldruck oder unter reduziertem Druck aus dem Gemisch entfernt und der Endpunkt mittel Festgehaltbestimmung ermittelt werden. Die Festgehalte liegen typischerweise in einem Bereich von 99.999 bis 95.0 Gew.%, bevorzugt von 99.998 bis 98.0 Gew.-% bezogen auf das Fluorurethan.

Bei den Matrixpolymeren kann es sich insbesondere um Polyurethane handeln. Vorzugsweise sind die Polyurethane durch Umsetzung einer Isocyanatkomponente a) mit einer Isocyanat-reaktiven Komponente b) erhältlich.

Die Isocyanatkomponente a) umfasst bevorzugt Polyisocyanate. Als Polyisocyanate können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di-oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-oktan oder deren Mischungen.

Ebenfalls können als Komponente a) NCO-funktionelle Prepolymere mit Urethan-, Allophanat-, Biuretund/oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die dem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können; sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatomethyl-1,8-octandiisocyanat (TIN), 2,4- und/oder 2,6-Toluen-diisocyanat.

Als isocyanatreaktive Verbindungen a2) zum Aufbau der Prepolymere werden bevorzugt OH- funktionelle Verbindungen eingesetzt. Diese sind analog den OH-funktionellen Verbindungen wie sie nachfolgend für die Komponente b) beschrieben sind.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und oligomeren oder polymeren Polyolen oder Polyaminen mit zahlenmittleren Molmassen von 500 bis 8500 g/Mol und ganz besonders bevorzugt sind Allophanate aus HDI oder TMDI und difunktionellen Polyetherpolyolen mit zahlenmittleren Molmassen von 1000 bis 8200 g/Mol.

Bevorzugt weisen die vorstehend beschriebenen Prepolymere Restgehalte an freiem monomeren Isocyanat von weniger als 1 Gew.%, besonders bevorzugt weniger als 0.5 Gew.-%, ganz besonders bevorzugt weniger als 0.2 Gew.% auf.

Selbstverständlich kann die Isocyanatkomponente anteilsmäßig neben den beschriebenen Prepolymeren weitere Isocyanatkomponenten enthalten. Hierfür kommen in Betracht aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-naphthylendiisocyanat, 2,4'- oder 4,4'-Diphenylmethandiisocyanat, Triphenylmethan-4,4',4''-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigten Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxy-ethyl(meth) acrylat, Polyethylenoxid-mono(meth)acrylate, Polypropylenoxidmono(meth)acrylate, Polyalkylenoxidmono(meth)acrylate, Poly($\varepsilon$-caprolacton)mono(meth)acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten die teilweise mit isocyanatreaktiven ethylenisch ungesättigten Verbindungen umgesetzt sind an der Isocyanatkomponente a) beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden können.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propaudiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität ≥ 2 beispielsweise der vorstehend genannten Art erhalten werden können.

Solche Polyesterpolyole haben bevorzugt zahlenmittlere Molmassen von 400 bis 4000 g/Mol, besonders bevorzugt von 500 bis 2000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Daneben sind Poly(trimethylenoxid)e sowie Mischungen der als bevorzugt genannten Polyole bevorzugt. Besonders bevorzugt sind Propylenoxid-homopolymere sowie statistische oder Block-Copolymere, die Oxymethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.% ausmacht. Oxypropylen- und Oxybutylen- umfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1.

Daneben sind als Bestandteile der Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende

aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Komponente c) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formeln der vorgenannten Polymerisationen eingesetzt.

(Typ 1)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxide, Phenylglyoxylsäureester, Campherchinon, alpha-Aminoalkylphenone, alpha-,alpha-Dialkoxyacetophenone, 1-[4-(Phenylthio)phenyl]octan-1,2-dion-2-(O-benzoyloxim), u n t erschiedlich substituierte Hexarylbisimidazole (HABI) mit geeigneten Coinitiatoren wie z.B. Mercaptobenzoxazol sowie alpha-Hydroxyalkylphenone. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetra-butylammonium Triphenylhexylborat, Tetrabutylammonium Triphenylbutylborat, Tetrabutylammonium Trinaphthylbutylborat, Tetramethylammonium Triphenylbenzylborat, Tetra(n-hexyl)ammonium (sec-Butyl)triphenylborat, 1-Methyl-3-octylimidazolium Dipentyldiphenylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Safranin O, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ 1)-Systeme und leiten sich von Übergangsmetall-Komplexen der ersten Reihe ab. Hier sind Chrom-Salze, wie z.B. trans-$Cr(NH_3)_2(NCS)_4$- (Kutal et al, Macromolecules 1991, 24, 6872) oder Ferrocenyl-Verbindungen (Yamaguchi et al. Macromolecules 2000, 33, 1152) zu nennen. Eine weitere Möglichkeit der anioni-schen Polymerisation besteht in der Verwendung von Farbstoffen, wie Kristallviolett Leukonitril oder Malachit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugen, das die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren $SbF_6$-, $AsF_6$- oder $PF_6$-. Für den Einsatz in Beschichtung dünner Filme sind diese Verbindungen i.d.R wenig geeignet, da durch den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalanion, welches sich durch H-Abstraktion stabilisiert und ein Proton freisetzt und dann die kationische Polymerisation startet (Dektar et al. J. Org. Chem. 1990, 55, 639; J. Org. Chem., 1991, 56. 1838). Dieser Mechanimus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls $SbF_6^-$, $AsF_6^-$ oder $PF_6^-$. Ansonsten in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6$ Salzen erzielt. Da die

Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivate (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren c) sind Mischungen aus Tetrabutylammonium Triphenylhexylborat, Tetrabutylammonium Triphenylbutylborat, Tetrabutylammonium Trinapthylbutylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Als Komponente d) sind mit hochbrechenden Acrylaten als kontrastgebenden Komponenten in Photopolymer-Formulierungen sehr gute Ergebnisse erzielbar, wie dies bespielsweise in der US 6,780,546 beschrieben ist.

Es ist daher erfindungsgemäß bevorzugt, wenn in der Photopolymer-Formulierung die Schreibmomomere Acrylate sind, besonders bevorzugt solche mit einem Brechungsindex $n_D^{20} > 1.50$. Ganz besonders bevorzugt sind Urethanacrylate, insbesondere bevorzugt sind aromatische Urethanacrylate mit einem Brechungsindex von $n_D^{20} > 1.50$ bei 589 nm, wie sie beispielsweise in WO2008/125199 beschrieben sind.

Weitere Gegenstände der vorliegenden Erfindung sind Medien zur Aufzeichnung visueller Hologramme erhältlich unter Verwendung von Fluorurethanen der Formel (I), die Verwendung solcher Medien als optische Elemente, Bilder oder zur Bilddarstellung oder -projektion sowie ein Verfahren zur Aufzeichnung eines Hologramms, bei solche Medien eingesetzt werden.

Die erfindungsgemäße Photopolymer-Formulierung kann insbesondere 15 bis 79, bevorzugt 30 bis 60 Gew.-% Matrixpolymer, 5 bis 50, bevorzugt 10 bis 40 Gew.-% Schreibmonomer, 1 bis 10, bevorzugt 1 bis 3 Gew.% Photoinitiator und 5 bis 50, bevorzugt 10 bis 40 Gew.-% Fluorurethane und 0 bis 10 Gew.% weitere Additive enthalten, wobei die Summe der Bestandteile 100 Gew.-% beträgt.

Ein zweiter Aspekt der Erfindung betrifft ein Verfahren zur Herstellung einer erfindungsgemäßen Photopolymer-Formulierung bei dem Matrixpolymere, Schreibmomomere, Photoinitiatoren und Fluorurethane als Weichmacher zu der Photopolymer-Formulierung vermischt werden.

Ein dritter Aspekt der Erfindung betrifft eine nach dem Verfahren erhältliche Photopolymer-Formulierung.

Ein vierter Aspekt der Erfindung betrifft eine Folie, einen Film, eine Schicht, einen Schichtaufbau oder einen Formkörper aus der Photopolymer-Formulierung.

Schichten, Schichtaufbauten und Formkörper aus den erfindungsgemäßen Photopolymer-Formulierungen weisen typischerweise Δn-Werte, gemessen nach dem im Abschnitt "Messung der holographischen Eigenschaften DE und Δn der holographischen Medien mittels Zweistrahlinterferenz in Reflexionsanordnung" beschriebenen Verfahren, von $\Delta n > 0.0120$ , bevorzugt > 0.0130, besonders bevorzugt > 0.0140, ganz besonders bevorzugt > 0.0150 auf.

Ein fünfter Aspekt der Erfindung betrifft die Verwendung der Photopolymer-Formulierung zur Herstellung von optischen Elementen, insbesondere zur Herstellung von holographischen Elementen und Bildern.

Ebenfalls Gegenstand der Erfindung ist ein Verfahren zur Belichtung von holographischen Medien aus einer erfindungemäßen Photopolymer-Formulierung, bei dem die Schreibmonomere durch elektromagnetische Strahlung ortsaufgelöst selektiv polymerisiert werden.

Derartige holographische Medien eignen sich nach der holographischen Belichtung zur Herstellung von holographischen optischen Elementen, die z.B. die Funktion einer optischen Linse, eines Spiegels, eines Umlenkspiegels, eines Filters, einer Streuscheibe, eines Beugungselements, eines Lichtleiters, eines Lichtlenkers, einer Projektionsscheibe und/oder einer Maske haben. Zudem können damit auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können, u.a auch in Kombination mit den zuvor dargestellten Produkten.

Im Stand der Technik sind bestimmte Fluorurethane bekannt. So beschreibt die US 2003/105263 A1 Fluorurethane, die durch Umsetzung eines Biuret, Isocyanurat, Uretdion, Polyharnstoff enthalten den Polyisocyanates mit einem fluoriertem Alkohol erhältlich sind. Aus der WO 03/023519 A ist Fluorurethan bekannt, dass durch Umsetzung eines Biuret enthaltenden Polyisocynates mit einem fluoriertem Alkohol erhältlich ist.

Ein weiterer Aspekt der Erfindung betrifft ein Fluorurethan, erhältlich durch Umsetzung Iminooxadiazindione

oder Oxadiazadion enthaltenden Polyisocyanates, das wenigstens eine freie Isocyanat Gruppe aufweist, mit einem Alkohol, wobei das Polyisocyanat und/oder der Alkohol mit wenigstens einem Fluoratom substituiert ist.

Schließlich ist auch ein Fluorurethan gemäß der allgemeinen Formel (III)

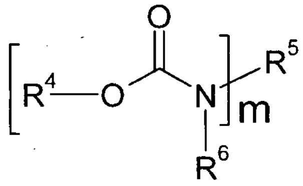

(III)

in der $m \geq 1$ und $m \leq 8$ ist und $R^4$, $R^5$, $R^6$ Wasserstoff und / oder unabhängig voneinander lineare, verzweigte, cyclische oder heterocyclische unsubstituierte oder gegebenenfalls auch mit mit Heteroatomen substituierte organische Reste sind und Iminooxadiazindion- und / oder Oxadiazadion-Strukturelemente aufweisen, wobei gleichzeitig wenigstens zwei der Reste $R^4$, $R^5$, $R^6$ mit wenigstens einem Fluoratom substituiert sind, Gegenstand der Erfindung.

**Beispiele:**

Die Erfindung wird im Folgenden anhand von Beispielen näher erläutert.

Sofern nicht abweichend vermerkt beziehen sich alle Prozentangaben auf Gewichtsprozent.

**Messmethoden:**

Die angegebenen NCO-Werte (Isocyanat-Gehalte) wurden gemäß DIN EN ISO 11909 bestimmt.

Die Messung des Brechungsindex erfolgte je nach Beschaffenheit der Beispiel-Verbindung nach einer der drei folgenden Methoden:

Messung des Brechungsindex n bei einer Wellenlänge von 405 nm (Methode A): Der Brechungsindex n in Abhängigkeit von der Wellenlänge der Proben wurden aus den Transmissions- und Reflexionsspektren erhalten. Dazu wurden ca. 100 - 300 nm dicke Filme der Proben auf Quarzglasträger aus verdünnter Lösung in Butylacetat aufgeschleudert. Das Transmissions- und Reflexionsspektrum dieses Schichtpaketes wurde mit einem Spektrometer der Firma STEAG ETA-Optik, CD-Measurement System ETA-RT gemessen und danach die Schichtdicke und der spektrale Verlauf von n an die gemessenen Transmissions- und Reflexionsspektren angepasst. Dies geschieht mit der internen Software des Spektrometers und erfordert zusätzlich die n Daten des Quarzglassubstrates, die in einer Blindmessung vorab bestimmt wurden.

Messung des Brechungsindex $n_D^{20}$ bei einer Wellenlänge von 589 nm (Methode B): Eine Probe der Beispiel-Verbindung wurde in ein Abbe-Refraktometer gegeben und dann der $n_D^{20}$ gemessen.

Messung des Brechungsindex $n_D^{20}$ bei einer Wellenlänge von 589 nm aus halbkonzentrierter Lösung (Methode C): Eine Probe der Beispiel-Verbindung wurde 50:50 (Gew.-%) mit N-Ethylpyrrolidon verdünnt und in ein Abbe-Refraktometer gegeben und dann der $n_D^{20}$ gemessen. Daraus wurde der genäherte Brechungsindex des Analyten berechnet, der $n_D^{20}$ von N-Ethylpyrrolidon war dabei 1.4658.

**Messung der holographischen Eigenschaften DE und Δn der holographischen Medien mittels Zweistrahlinterferenz in Reflexionsanordnung**

Die hergestellten Medien wurden anschließend mittels einer Messanordnung gemäß Figur 1 wie folgt auf ihre holographischen Eigenschaften geprüft:

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (1) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die λ/2 Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der

Einfallswinkel ($\alpha_0$) des Referenzstrahls beträgt -21.8°, der Einfallswinkel ($\beta_0$) des Signalstrahls beträgt 41.8°. Die Winkel werden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 225 nm (der Brechungsindex des Mediums zu ~1.504 angenommen).

Figur 1 zeigt die Geometrie eines Holographic Media Testers (HMT) bei $\lambda$ = 633 nm (He-Ne Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha_0$ = -21.8°, $\beta_0$ = 41.8° sind die Einfallswinkel der kohärenten Strahlen außerhalb der Probe (des Mediums) gemessen. RD = Referenzrichtung des Drehtisches.

Mit einem holographischen Versuchsaufbau wie in Figur 1 dargestellt wurde die Beugungseffizienz (DE) der Medien gemessen.

Es wurden auf folgende Weise Hologramme in das Medium geschrieben:

- Beide Shutter (S) sind für die Belichtungszeit *t* geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also $\alpha_0$ = -31.8° und $\beta_0$ = 31.8° gilt. Dann beträgt $\Omega_{recording}$ = 0°. Für $\alpha_0$ = -21.8° und $\beta_0$ = 41.8° beträgt $\Omega_{recording}$ daher 10°. Allgemein gilt für das Interferenzfeld beim Schreiben ("recording") des Hologramms:

$$\alpha_0 = \theta_0 + \Omega_{recording}.$$

$\theta_0$ ist der Halbwinkel im Laborsystem außerhalb des Mediums und es gilt beim Schreiben des Hologramms:

$$\theta_0 = \frac{\alpha_0 - \beta_0}{2}.$$

In diesem Fall gilt also $\theta_0$ = -31.8°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des trans-mittierten Strahls.

Mittels des oben beschriebenen Verfahrens wurde die Braggkurve, sie beschreibt den Beugungswirkungsgrad $\eta$ in Abhängigkeit des Drehwinkels $\Omega$ des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die maximale Beugungseffizienz (DE = $\eta_{max}$) des Hologramms, also sein Spitzenwert, wurde bei $\Omega_{re\text{-}construction}$ ermittelt. Eventuell musste dazu die Position des Detektors des abgebeugten Strahls verändert werden, um diesen maximalen Wert zu bestimmen.

Der Brechungsindexkontrast Δn und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand A' des Hologramms und die Orientierung der Streifen (slant) vom Streifenabstand A des Interferenzmusters und dessen Orientierung abweichen kann. Demnach wird auch der Winkel Ao' bzw. der entsprechende Windel des Drehtisches $\Omega_{reconstrution}$, bei dem maximale Beugungseffizienz erreicht wird von 0 bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:

Alle geometrischen Größen, die sich auf das geschriebene Hologramm beziehen und nicht auf das Interferenzmuster werden als gestrichene Größen dargestellt.

Für die Braggkurve η(Ω) eines Reflexionshologramms gilt nach Kogelnik:

$$\eta = \begin{cases} \dfrac{1}{1 - \dfrac{1-(\xi/\nu)^2}{\sin^2\left(\sqrt{\xi^2-\nu^2}\right)}}, \text{ für } \nu^2 - \xi^2 < 0 \\[2ex] \dfrac{1}{1 + \dfrac{1-(\xi/\nu)^2}{\sinh^2\left(\sqrt{\nu^2-\xi^2}\right)}}, \text{ für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left(2 \cdot \cos(\psi' - \vartheta') - \frac{\lambda}{n \cdot \Lambda'}\right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$

$$\sin(\vartheta'_0) = n \cdot \sin(\vartheta')$$

An der Bragg-Bedingung ist das "Dephasing" DP = 0. Und es folgt entsprechend:

$$\alpha'_0 = \theta_0 + \Omega_{reconstruction}$$

$$\sin(\alpha'_0) = n \cdot \sin(\alpha')$$

Der noch unbekannte Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot [\sin(\alpha_0) + \sin(\beta_0) - \sin(\theta_0 + \Omega_{reconstruction})]$$

ν ist die Gitterstärke, ξ ist der Detuning Parameter und ψ' die Orientierung (Slant) des Brechungsindexgitters das geschrieben wurde. α' und β' entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzt. λ ist die Wellenlänge des Laserlichts im Vakuum.

Die maximale Beugungseffizienz (DE = ηmax) ergibt sich dann für ξ = 0 zu:

$$DE = \tanh^2(\nu) = \tanh^2\left(\frac{\pi \cdot \Delta n \cdot d'}{\lambda \cdot \sqrt{\cos(\alpha') \cdot \cos(\alpha' - 2\psi)}}\right)$$

Figur 2 zeigt die gemessene transmittierte Leistung $P_T$ (rechte γ-Achse) als durchgezogene Linie gegen das Winkeldetuning ΔΩ aufgetragen, die gemessene Beugungseffizienz η (linke γ-Achse) als ausgefüllte Kreise gegen das Winkeldetuning ΔΩ aufgetragen (soweit die endliche Größe des Detektors es erlaubte) und die Anpassung der Kogelnik Theorie als gestrichelte Linie (linke λ-Achse).

Die Messdaten der Beugungseffizienz, die theoretische Braggkurve und die transmittierte Intensität werden wie in Figur 2 gezeigt gegen den zentrierten Drehwinkel $\Delta\Omega \equiv \Omega_{reconstrution} - \Omega = \alpha'_0 - \vartheta'_0$, auch Winkeldetuning genannt, aufgetragen.

Da DE bekannt ist wird die Form der theoretischen Braggkurve nach Kogelnik nur noch durch die Dicke *d'* der Photopolymerschicht bestimmt. Δn wird über DE für gegebene Dicke *d'* so nachkorrigiert, dass Messung und Theorie von DE immer übereinstimmen. *d'* wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für die theoretische Braggkurve und für die transmittierte Intensität übereinstimmen.

Da die Richtung in der ein Reflexionshologramm bei der Rekonstruktion mittels eines Ω-Scans mitrotiert, der Detektor für das abgebeugte Licht aber nur einen endlichen Winkelbereich erfassen kann, wird die Braggkurve von breiten Holgrammen (kleines *d'*) bei einem Ω-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 2 zeigt die Darstellung der Braggkurve η nach der Coupled Wave Theorie (gestrichelte Linie), des gemessenen Beugungswirkungsgrades (ausgefüllte Kreise) und der transmittierten Leistung (schwarz durchgezogene Linie) gegen das Winkeldetuning ΔΩ.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis *E* ergibt sich wie folgt aus den Leistungen der zwei den Winkeln $\alpha_0$ und $\beta_0$ zugeordneten Teilstrahlen (Referenzstrahl mit $P_r$ = 0.50 mW und Signalstrahl mit $P_s$ = 0.63 mW), der Belichtungszeit t und dem Durchmesser der Irisblende (0.4 cm):

$$E\,(\mathrm{mJ/cm^2}) = \frac{2\cdot\left[P_r + P_s\right]\cdot t\,(\mathrm{s})}{\pi\cdot 0.4^2\ \mathrm{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

**<u>Verwendete Substanzen:</u>**

Fluorlink E 10/H ist ein von Solvay Solexis hergestelltes Reaktiv-Additiv auf Basis einer fluorierten Alkohols mit dem mittleren Molgewicht von 750 g/Mol.

CGI-909 (Tetrabutylammonium-tris(3-chlor-4-methylphenyl)(hexyl)borat, [1147315-11-4]) ist ein von der Fa. CIBA Inc., Basel, Schweiz, hergestelltes Versuchsprodukt.

1,8-Diisocyanato-4-(isocyanatomethyl)octan (TIN) wurde wie in EP749958 beschrieben hergestellt.

Die eingesetzten fluorierten Alkohole und monofunktionellen Isocyanate wurden im Chemikalienhandel bezogen, die verwendeten Polyisocyanate (Desmodur H (HDI), Desmodur I (IPDI), Desmodur W, Desmodur LD, Desmodur N3400, Desmodur N3600, Desmodur N3900, Baymicron OXA) sind Handelsprodukte der Bayer MaterialScience AG, Leverkusen, Deutschland.

2,4,4-Trimethylhexane-1,6-diisocyanat, Vestanat TMDI, ist ein Produkt der Evonik Degussa GmbH, Marl, Deutschland.

**Herstellung von 2,2,2-Trifluorethyl-(6-isocyanatohexyl)carbamat**

In einem 1 L Rundkolben wurden 684 g Hexamethylendiisocyanat (HDI) bei 80 °C vorgelegt und 0.002 g Isophthalsäuredichlorid zugesetzt. Es wurden 54.4 g Trifluorethanol langsam zugetropft und nachgerührt, bis der NCO Wert bei 43.2 Gew.% lag. Das Gemisch wurde destillativ an einem Dünnschichtverdampfer aufgetrennt und man erhielt 47 g (=47 % der Theorie) der Titelverbindung mit einem NCO-Gehalt von 22.7 Gew.-%.

**Herstellung von 2,2,3,3,4,4,5,5-Octafluoropentyl-(6-isocyanatohexyl)carbamat**

In einem 1 L Rundkolben wurden 399 g Hexamethylendiisocyanat (HDI) bei 80 °C vorgelegt und 0.002 g Isophthalsäuredichlorid zugesetzt. Es wurden 73.4 g 2,2,3,3,4,4,5,5-Octafluoropentanol langsam zugetropft und nachgerührt, bis der NCO Wert bei 39.4 Gew.-% lag. Das Gemisch wurde destillativ an einem Dünnschichtverdampfer aufgetrennt und man erhielt 40 g (=40 % der Theorie) der Titelverbindung mit einem NCO-Gehalt von 12.4 Gew.-%.

**<u>Beispiel 1: Bis(2,2,2-trifluoroethyl)hexan-1,6-diylbiscarbamat</u>**

In einem 500 mL Rundkolben wurden 0.07 g Desmorapid Z und 64.4 g 6-Diisocyanatohexan (HDI) vorgelegt und auf 60 °C erwärmt. Anschließend wurden 81.5 g Trifluorethanol zugetropft und die Mischung weiter auf 60 °C gehalten, bis der Isocyanatgehalt unter 0.1 % gesunken war. Danach wurde abgekühlt. Das Produkt wurde als farbloser Feststoff erhalten.

Die nachfolgend in Tabelle 1 beschriebenen Beispiele wurden auf die in Beispiel 1 beschriebene Art und Weise in den angegebenen Zusammensetzungen hergestellt.

**Tabelle 1: Herstellung und Charakterisierung der Beispiele 2-224**

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **2** | 2,2,2-Trifluorethyl-butylcarbamat | n-Butylisocyanat 498 g | Trifluorethanol 502 g | Desmorapid Z 0.50 g | 60°C | farblose Flüssigkeit | 1.3900 (B) |
| **3** | 2,2,2-Trifluorethyl-isopropylcarbamat | i-Propylisocyanat 22.9 g | Trifluorethanol 27.0 g | Desmorapid Z 0.02 g | 60°C | farbloser Feststoff | 1.3834 (C) |
| **4** | 2,2,2-Trifluorethyl-hexylcarbamat | n-Hexylisocyanat 55.9 g | Trifluorethanol 44.0 g | Desmorapid Z 0.05 g | 60°C | farblose Flüssigkeit | 1.3984 (B) |
| **5** | 1,1,1,3,3,3-Hexafluorpropan-2-yl-hexylcarbamat | n-Hexylisocyanat 10.8 g | Hexafluor-2-propanol 14.2 g | Desmorapid Z 0.01 g | 60 °C | farblose Flüssigkeit | 1.3711 (B) |
| **6** | 2,2,3,3-Tetrafluorpropyl-hexylcarbamat | n-Hexylisocyanat 12.3 g | 2,2,3,3-Tetra-fluorpropan-1-ol 12.7 g | Desmorapid Z 0.01g | 60 °C | farblose Flüssigkeit | 1.4020 (B) |
| **7** | 1,1,1,3,3,3-Hexafluorpropan-2-yl-butylcarbamat | n-Butylisocyanat 9.3 g | Hexafluor-2-propanol 15.7 g | Desmorapid Z 0.01 g | 60 °C | farbloser Feststoff | 1.3650 (C) |
| **8** | 2,2,3,3-Tetrafluorpropyl-butylcarbamat | n-Butylisocyanat 10.7 g | 2,2,3,3-Tetra-fluorpropan-1-ol 14.3 g | Desmorapid Z 0.01 g | 60 °C | farblose Flüssigkeit | 1.4100 (A) |
| **9** | 1,1,1,3,3,3-Hexafluorpropan-2-yl-octylcarbamat | n-Octylisocyanat 9.6 g | Hexafluor-2-propanol 10.4 g | Desmorapid Z 0.01 g | 60 °C | farbloser Feststoff | 1.3910 (A) |
| **10** | 2,2,2-Trifluorethyl-octylcarbamat | n-Octylisocyanat 12.2 g | Trifluorethanol 7.8 g | Desmorapid Z 0.01 g | 60 °C | farblose Flüssigkeit | 1.4083 (B) |
| **11** | 1,1,1,3,3,3-Hexafluorpropan-2-yl-octylcarbamat | n-Decylisocyanat 10.4 g | Hexafluor-2-propanol 9.6 g | Desmorapid Z 0.01 g | 60 °C | farbloser Feststoff | 1.4022 (C) |
| **12** | 2,2,2-Trifluorethyl-decylcarbamat | n-Decylisocyanat 12.9 g | Trifluorethanol 7.1 g | Desmorapid Z 0.01 g | 60 °C | farbloser Feststoff | 1.4178 (C) |
| **13** | Bis(1,1,1,3,3,3-hexafluorpropan-2-yl)-hexan-1,6-diylbiscarbamat | 6-Diisocyanatohexan (HDI) 6.7 g | Hexafluor-2-propanol 13.3 g | Desmorapid Z 0.01 g | 60 °C | farbloser Feststoff | 1.4300 (A) |
| **14** | Bis(1,1,1,3,3,3-hexafluorpropan-2-yl)-(2,2,4-trimethylhexan-1,6-diyl) biscarbamat | 2,4,4-Tiimethywex-ane-1,6-diisocyanat (TMDI) 50.0 g | Hexafluor-2-propanol 80.0 g | Desmorapid Z 0.07 g | 60 °C | farblose Flüssigkeit | 1.4270 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **15** | Bis(2,2,2-trifluorethyl)-(2,2,4-trimethylhexan-1,6-diyl)biscarbamat | 2,4,4-Trimethylhex-ane-1,6-diisocyanat (TMDI) 496 g | Trifluorethanol 463 g | Desmorapid Z 0.48 G | 60 °C | farblose Flüssigkeit | 1.4800 (A) |
| **16** | 1,1,1,3,3,3-Hexafluorpropan-2-yl-stearylcarbamat | Stearylisocyanat 12.7 g | Hexafluor-2-propanol 7.27 g | Desmorapid Z 0.01 g | 60 °C | farbloser Feststoff | n.b. |
| **17** | 2,2,2-Trifluorethyl-stearylcarbamat | Stearylisocyanat 14.9 g | Trifluorethanol 5.1 g | Desmorapid Z 0.01 g | 60 °C | farbloser Feststoff | n.b. |
| **18** | Bis(1,1,1,3,3,3-hexafluorpropan-2-yl)-{4-[({[(1,1,1,3,3,3-hexafluorpropan-2-yl) oxy]carbonyl}amino)methyl]octan-1,8-diyl}biscarbamat | 1,8-Diisocyanato-4-(isocyanatomethyl)octan (TIN) 3.33 g | Hexafluor-2-propanol 6.66 g | Desmorapid Z 0.01 g | 60 °C | farbloser Feststoff | 1.3920 (B) |
| **19** | Bis(2,2,2-trifluorethyl)-[4-({[(2,2,2-trifluoretho-xy)carbonyl]amino}methyl) octan-1,8-diyl]biscarbamat | 1,8-Diisocyanato-4-(iso-cyanatomethyl)octan (TIN) 228 g | Trifluorethanol 272 g | Desmorapid Z 0.48 g | 60 °C | farblose Flüssigkeit | 1.4213 (B) |
| **20** | 2,2,3,3,4,4,4-Heptafluorbutylbutylcarbamat | n- Butylisocyanat 24.8 g | 2,2,3,3,4,4,4-Heptafluorbutanol 50.1 g | Desmorapid Z 0.04 g | 60 °C | farbloser Feststoff | 1.3625 (B) |
| **21** | 2,2,3,3,4,4,5,5,6,6,7,7,8,8,9,9-Hexadecafluornonyl-butylcarbamat | n-Butylisocyanat 186 g | 2,2,3,3,4,4,5,5,6,6,7,7,8,8,9,9-Hexadecafluornonanol 813 g | Desmorapid Z 0.50 g | 60 °C | farblose Flüssigkeit | 1.3555 (B) |
| **22** | Bis(2,2,3,3,4,4,4-heptafluorbutyl)-(2,2,4-trimethylhexan-1,6-diyl)biscarbamat | 2,4,4-Trimethylhexane-1,6-diisocyanat (TMDI) 6.88 g | 2,2,3,3,4,4,4-Hepta-fluorbutanol 13.1 g | Desmorapid Z 0.01 g | 60 °C | farblose Flüssigkeit | 1.3887 (B) |
| **23** | Bis(2,2,3,3,4,4,5,5,6,6,7,7,8,8,9,9-hexadecafluornonyl)-(2,2,4-trimethylhexan-1,6-diyl)biscarbamat | 2,4,4-Trimethylhexane-1,6-diisocyanat (TMDI) 3.91 g | 2,2,3,3,4,4,5,5,6,6,7,7,8,8,9,9-Hexadecafluornonanol 16.1 g | Desmorapid Z 0.01 g | 60 °C | farblose Flüssigkeit | 1.3733 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **24** | Bis(2,2,3,3,4,4,4-heptafluorbutyl)-[4-({[(2,2,3,3,4,4,4-heptafluorbutoxy)-carbonyl]amino}methyl)octan-1,8-diyl]biscarbamat | 1,8-Diisocyanato-4-(isocyanatomethyl)octan (TIN) 5.91 g | 2,2,3,3,4,4,4-Heptafluorbutanol 14.1 g | Desmorapid Z 0.01 g | 60 °C | farbloses Öl | 1.3876 (B) |
| **25** | Bis(2,2,3,3,4,4,5,5,6,6,7,7,8,8,9,9-hexadecafluornonyl)-{4-[({[(2,2,3,3,4,4,5,5,6,6,7,7,8,8,9,9-hexadecafluomonyl)oxy]carbonyl}-amino)methyl]octan-1,8-diyl}biscarbamat | 1,8-Diisocyanato-4-(isocyanatomethyl)octan (TIN) 3.25 g | 2,2,3,3,4,4,5,5,6,6,7,7,8,8,9,9-Hexadecafluornonanol 16.7g | Desmorapid Z 0.01 g | 60 °C | farbloses Öl | 1.3890 (C) |
| **26** | 2,2,3,3,4,4,5,5,5-Nonafluorpentyl-butylcarbamat | n-Butylisocyanat 4.25 g | 2,2,3,3,4,4,5,5,5-Nonafluorpentan-1-ol 10.7 g | Desmorapid Z 0.02 g | 70 °C | farblose Flüssigkeit | 1.3580 (B) |
| **27** | Bis(2,2,3,3,4,4,5,5,5-nonafluorpentyl)-{4-[({[(2,2,3,3,4,4,5,5,5-nona-fluorpentyl)oxy]-carbonyl}amino)methyl]octan-1,8-diyl}biscarbamat | 1,8-Diisocyanato-4-(iso-cyanatomethyl)octan (TIN) 3.77 g | 2,2,3,3,4,4,5,5,5-Nonafluorpentan-1-ol 11.2 g | Desmorapid Z 0.02 g | 70 °C | farbloses Öl | 1.3786 (B) |
| **28** | Bis(2,2,3,3,4,4,5,5,5-nonafluorpentyl)-(2,2,4-trimethylhexan-1,6-diyl)biscarbamat | 2,4,4-Trimethylhexane-1,6-diisocyanat (TMDI) 4.43 g | 2,2,3,3,4,4,5,5,5-Nonafluorpentan-1-ol 10.6 g | Desmorapid Z 0.02 g | 70 °C | farblose Flüssigkeit | 1.3820 (B) |
| **29** | Bis(2,2,3,3,4,4,5,5,5-nonafluorpentyl)-hexan-1,6-diylbiscarbamat | 6-Diisocyanatohexan (HDI) 3.77 g | 2,2,3,3,4,4,5,5,5-Nonafluorpentan-1-ol 11.2 g | Desmorapid Z 0.02 g | 70 °C | farbloser Feststoff | 1.3876 (C) |
| **30** | Bis(2,2,3,3,4,4,5,5,5-nonafluorpentyl)-(methandiyldicyclohexan-4,1-diyl)biscarbamat | Dicyclohexyl-methandiisocyanat (Desmodur W) 5.15 g | 2,2,3,3,4,4,5,5,5-Nonafluorpentan-1-ol 9.83 g | Desmorapid Z 0.02 g | 70 °C | farbloser Feststoff | 1.4124 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **31** | 2,2,3,3,4,4,5,5,5-Nonafluorpentyl-{[1,3,3-trimethyl-5-({[(2,2,3,3,4,4,5,5,5-nonafluorpentyl)oxy]carbonyl} amino)-cyclohexyl]methyl}carbamat | 1-Isocyanato-3,3,5-trimethyl-5-iso-cyanatomethyl-cyclohexan (IPDI) 4.61 g | 2,2,3,3,4,4,5,5,5-Nonafluorpentan-1-ol 10.4 g | Desmorapid Z 0.02 g | 70 °C | farbloser Feststoff | 1.3984 (C) |
| **32** | 2,2,3,3,4,4,5,5,5-Nonafluorpentyl-hexylcarbamat | n-Hexylisocyanat 5.05 g | 2,2,3,3,4,4,5,5,5-Nonafluorpentan-1-ol 9.94 g | Desmorapid Z 0.02 g | 70 °C | farblose Flüssigkeit | 1.3690 (B) |
| **33** | Bis(2,2,3,3,4,4,5,5,5-nonafluorpentyl)-(4-methylcyclohexan-1,3-diyl)biscarbamat | Hexahydrotoluylendiisocyanat (H6TDI) 3.97 g | 2,2,3,3,4,4,5,5,5-Nonafluorpentan-1-ol 11.0 g | Desmorapid Z 0.02 g | 70 °C | farbloses Öl | 1.3940 (C) |
| **34** | 2,2,3,3,4,4,5,5,5-Nonafluorpentyl-propan-2-ylcarbamat | 1-Propylisocyanat 3.81 g | 2,2,3,3,4,4,5,5,5-Nonafluorpentan-1-ol 11.2 g | Desmorapid Z 0.02 g | 70 °C | farblose Flüssigkeit | 1.3497 (B) |
| **35** | 2,2,3,3,4,4,5,5,5-Nonafluorpentyl-cyclohexylcarbamat | Cyclohexylisocyanat 5.00 g | 2,2,3,3,4,4,5,5,5-Nonafluorpentan-1 ol 10.0 g | Desmorapid Z 0.02 g | 70 °C | farbloser Feststoff | 1.3952 (C) |
| **36** | 2,2,3,3,4,4,5,5,6,6,6-Undecafluorhexyl-butylcarbamat | n-Butylisocyanat 3.72 g | 2,2,3,3,4,4,5,5,6,6,6-Undecafluorhexan-1-ol 11.3 g | Desmorapid Z 0.02 g | 70 °C | farblose Flüssigkeit | 1.3538 (B) |
| **37** | Bis(2,2,3,3,4,4,5,5,6,6,6-undecafluorhexyl)-(4-[({[ (2,2,3,3,4,4,5,5,6,6,6-undecafluorhexyl) oxy]-carbonyl} amino)methyl]octan-1,8-diyl}biscarbamat | 1,8-Diisocyanato-4-(isocyanatomethyl)octan (TIN) 3.28 g | 2,2,3,3,4,4,5,5,6,6,6-Undecafluorhexan-1-ol 11.7 g | Desmorapid Z 0.02 g | 70 °C | farbloses Öl | 1.3721 (B) |
| **38** | Bis(2,2,3,3,4,4,5,5,6,6,6-undecafluorhexyl)-(2,2,4-trimethylhexan-1,6-diyl)biscarbamat | 2,4,4-Trimethylhexane-1,6-diisocyanat (TMDI) 3.88 g | 2,2,3,3,4,4,5,5,6,6,6-Undecafluorhexan-1-ol 11.1 g | Desmorapid Z 0.02 g | 70 °C | farbloses Öl | 1.3750 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **39** | Bis(2,2,3,3,4,4,5,5,6,6,6-undecafluorhexyl)-hexan-1,6-diylbiscarbamat | 6-Diisocyanatohexan (HDI) 3.28 g | 2,2,3,3,4,4,5,5,6,6,6-Undecafluorhexan-1-ol 11.7 g | Desmorapid Z 0.02 g | 70 °C | farbloser Feststoff | 1.3826 (C) |
| **40** | Bis(2,2,3,3,4,4,5,5,6,6,6-undecafluorhexyl)-(methandiyldicyclohexan-4,1-diyl)biscarbamat | Dicyclohexylmethandiisocyanat (Desmodur W) 4.55 g | 2,2,3,3,4,4,5,5,6,6,6-Undecafluorhexan-1-ol 10.4 g | Desmorapid Z 0.02 g | 70 °C | farbloser Feststoff | 1.4084 (C) |
| **41** | 2,2,3,3,4,4,5,5,6,6,6-Undecafluorhexyl-{[1,3,3-trimethyl-5-({[(2,2,3,3,4,4,5,5,6,6,6-undeca-fluorhexyl)oxy]carbonyl}ainino)cyclo-hexyl]methyl}carbamat | 1-Isocyanato-3,3,5-trimethyl-5-isocyanatomethyl-cyclohexan (IPDI) 4.05 g | 2,2,3,3,4,4,5,5,6,6,6-Undecafluorhexan-1-ol 10.9 g | Desmorapid Z 0.02 g | 70 °C | farbloser Feststoff | 1.4014 (C) |
| **42** | 2,2,3,3,4,4,5,5,6,6,6-Undecafluorhexyl-he.xylcarbarnat | n-Hexylisocyanat 4.46 g | 2,2,3,3,4,4,5,5,6,6,6-Undecafluorhexan-1-ol 10.5 g | Desmorapid Z 0.02 g | 70 °C | farblose Flüssigkeit | 1.3640 (B) |
| **43** | Bis(2,2,3,3,4,4,5,5,6,6,6-undecafluorhexyl)-(4-methylcyclohexan-1,3-diyl)biscarbamat | Hexahydrotoluylendiisocyanat (H6TD1) 3.46 g | 2,2,3,3,4,4,5,5,6,6,6-Undecafluorhexan-1-ol 11.5 g | Desmorapid Z 0.02 g | 70 °C | farbloser Feststoff | 1.3916 (C) |
| **44** | 2,2,3,3,4,4,5,5,6,6,6-Undecafluorhexyl-propan-2-ylcarbamat | i-Propylisocyanat 3.31. g | 2,2,3,3,4,4,5,5,6,6,6-Undecafluorhexan-1-ol 11.7 g | Desmorapid Z 0.02 g | 70 °C | farbloser Feststoff | 1.3706 (C) |
| **45** | 2,2,3,3,4,4,5,5,6,6,6-Undecafluorhexyl-cyclohexylcarbamat | Cyclohexylisocyanat 4.41 g | 2,2,3,3,4,4,5,5,6,6,6-Undecafluorhexan-1-ol 10.6 g | Desmorapid Z 0.02 g | 70 °C | farbloser Feststoff | 1.3956 (C) |
| **46** | 2,2,3,3,4,4,5,5,6,6,7,7-Dodecafluorheptyl-butylcarbamat | n-Butylisocyanat 3.44 g | 2,2,3,3,4,4,5,5,6,6,7,7-Dodecafluorheptan-1-ol 11.5 g | Desmorapid Z 0.02 g | 70 °C | farblose Flüssigkeit | 1.3627 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **47** | Bis(2,2,3,3,4,4,5,5,6,6,7,7-dodecafluorheptyl)-{4-[({[(2,2,3,3,4,4,5,5,6,6,7,7-dodecafluorheptyl)-oxy]carbonyl}amino) methyl]octan-1,8-diyl}biscarbamat | 1,8-Diisocyanato-4-(iso-cyanatomethyl)octan (TIN) 3.03 g | 2,2,3,3,4,4,5,5,6,6,7,7-Dodecafluorheptan-1-ol 11.9 g | Desmorapid Z 0.02 g | 70 °C | farblose Flüssigkeit | 1.3807 (B) |
| **48** | Bis(2,2,3,3,4,4,5,5,6,6,7,7-dodecafluorheptyl)-(2,2,4-trimethylhexan-1,6-diyl)biscarbamat | 2,4,4-Trimethylhexane-1,6-diisocyanat (TMDI) 3.60 g | 2,2,3,3,4,4,5,5,6,6,7,7-Dodecafluorheptan-1-ol 11.4 g | Desmorapid Z 0.02 g | 70 °C | farbloses Öl | 1.3839 (B) |
| **49** | Bis(2,2,3,3,4,4,5,5,6,6,7,7-dodecafluorheptyl)-hexan-1,6-diylbiscarbamat | 6-Diisocyanatohexan (HDI) 3.03 g | 2,2,3,3,4,4,5,5,6,6,7,7-Dodecafluorheptan-1-ol 11.9 g | Desmorapid Z 0.02 g | 70 °C | farbloser Feststoff | 1.3944 (C) |
| **50** | Bis(2,2,3,3,4,4,5,5,6,6,7,7-dodecafluorheptyl)-(methandiyldicyclohexan-4,1-diyl)biscarbamat | Dicyclohexyl-methan-diisocyanat (Desmodur W) 4.24 g | 2,2,3,3,4,4,5,5,6,6,7,7-Dodecafluorheptan-1-ol 10.8 g | Desmorapid Z 0.02 g | 70 °C | farbloser Feststoff | 1.4160 (A) |
| **51** | 2,2,3,3,4,4,5,5,6,6,7,7-Dodecafluorheptyl-{3-[({[(2,2,3,3,4,4,5,5,6,6,7,7-dodecafluorheptyl)oxy]carbonyl}amino) methyl]-3,5,5-trimethylcyclohexyl} carbamat | 1-Isocyanato-3,3,5-trimethyl-5-isocyanatomethylcyclohexan (IPDI) 3.75 g | 2,2,3,3,4,4,5,5,6,6,7,7-Dodecafluorheptan-1-ol 11.2 g | Desmorapid Z 0.02 g | 70 °C | farblose Flüssigkeit | 1.4080 (A) |
| **52** | 2,2,3,3,4,4,5,5,6,6,7,7-Dodecafluorheptyl-hexylcarbamat | n-Hexylisocyanat 4.15 g | 2,2,3,3,4,4,5,5,6,6,7,7-Dodecafluorheptan-1-ol 10.8 g | Desmorapid Z 0.02 g | 70 °C | farblose Flüssigkeit | 1.3716 (B) |
| **53** | Bis(2,2,3,3,4,4,5,5,6,6,7,7-dodecafluorheptyl)-(4-methylcyclohexan-1,3-diyl)biscarbamat | Hexahydrotoluylen-diisocyanat (H6TDI) 3.20 g | 2,2,3,3,4,4,5,5,6,6,7,7-Dodecafluorheptan-1-ol 11.8 g | Desmorapid Z 0.02 g | 70 °C | farbloser Feststoff | 1.4020 (A) |
| **54** | 2,2,3,3,4,4,5,5,6,6,7,7-Dodecafluorheptyl-propan-2-ylcarbamat | i-Propylisocyanat 3.06 g | 2,2,3,3,4,4,5,5,6,6,7,7-Dodecafluorheptan-1-ol 11.93 g | Desmorapid Z 0.02 g | 70 °C | farblose Flüssigkeit | 1.3563 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **55** | 2,2,3,3,4,4,5,5,6,6,7,7-Dodecafluorheptylcyclohexylcarbamat | Cyclohexylisocyanat 4.10 g | 2,2,3,3,4,4,5,5,6,6,7,7-Dodecafluorheptan-1-ol 10.9 g | Desmorapid Z 0.02 g | 70 °C | farblose Flüssigkeit | 1.3830 (B) |
| **56** | 2,2,3,3,4,4,5,5,6,6,7,7,8,8,8-Pentadecafluoroctyl-butylcarbamat | n-Butylisocyanat 2.97 g | 2,2,3,3,4,4,5,5,6,6,7,7,8,8,8-Pentadeca-fluoroctan-1-ol 12.0 g | Desmorapid Z 0.02 g | 70 °C | farblose Flüssigkeit | 1.3488 (B) |
| **57** | Bis(2,2,3,3,4,4,5,5,6,6,7,7,8,8,8-pentadecafluoroctyl)-{4-[({[(2,2,3,3,4,4,5,5,6,6,7,7,8,8,8-pentadecafluoroctyl)oxy]carbönyl}-amino)methyl]octan-1,8-diyl}biscarbamat | 1,8-Diisocyanato-4-(isocyanatomethyl)octan (TIN) 2.60 g | 2,2,3,3,4,4,5,5,6,6,7,7,8,8,8-Pentadecafluoroctan-1-ol 12.4 g | Desmorapid Z 0.02 g | 70 °C | farbloses Öl | n.b. |
| **58** | Bis(2,2,3,3,4,4,5,5,6,6,7,7,8,8,8-pentadecafluoroctyl)-(2,2,4-trimethylhexan-1,6-diyl)biscarbainat | 2,4,4-Trimethylhexane-1,6-diisocyanat (TMDI) 3.12 g | 2,2,3,3,4,4,5,5,6,6,7,7,8,8,8-Pentadeca-fluoroctan-1-ol 11.9 g | Desmorapid Z 0.02 g | 70 °C | Öl farbloses | 1.3798 (B) |
| **59** | Bis(2,2,3,3,4,4,5,5,6,6,7,7,8,8,8-pentadecafluoroctyl)-hexan-1,6-diylbiscarbamat | 6-Diisocyanatohexan (HDI) 2.60 g | 2,2,3,3,4,4,5,5,6,6,7,7,8,8,8-Pentadecafluoroctan-1-ol 12.4 g | Desmorapid Z 0.02 g | 70 °C | farbloser Feststoff | n.b. |
| **60** | Bis(2,2,3,3,4,4,5,5,6,6,7,7,8,8,8-pentadecafluoroctyl)-(methandiyldicyclohexan-4,1diyl)biscarbamat | Dicyclohexylmethan-diisocyanat (Desmodur W) 3.70 g | 2,2,3,3,4,4,5,5,6,6,7,7,8,8,8-Pentadecafluoroctan-1-ol 11.3 g | Desmorapid Z 0.02 g | 70 °C | farbloser Feststoff | n.b. |
| **61** | 2,2,3,3,4,4,5,5,6,6,7,7,8,8,8-Pentadecafluoroctyl- {[1,3,3-trimethyl-5-({[(2,2,3,3,4,4,5,5,6,6,7,7,8,8,8-pentadecafluoroctyl)oxy]carbonyl}amino)cyclohexyl]m ethyl}carbamat | 1-Isocyanato-3,3,5-trimethyl-5-isocyanatomethyl-cyclohexan (IPDI) 3.25 g | 2,2,3,3,4,4,5,5,6,6,7,7,8,8,8-Pentadecafluoroctan-1-ol 11.7 g | Desmorapid Z 0.02 g | 70 °C | farblose Flüssigkeit | 1.3747 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **62** | 2,2,3,3,4,4,5,5,6,6,7,7,8,8,8-Pentadecafluoroctyl-hexylcarbamat | n-Hexylisocyanat 3.61 g | 2,2,3,3,4,4,5,5,6,6,7,7,8,8,8-Pentadeca-fluoroctan-1-ol 11.4 g | Desmorapid Z 0.02 g | 70 °C | farblose Flüssigkeit | 1.3595 (B) |
| **63** | Bis(2,2,3,3,4,4,5,5,6,6,7,7,8,8,8-pentadecafluoroctyl)-(4-methylcyclohexan-1,3-diyl)biscarbamat | Hexahydroto luylen-diisocyanat (H6TDI) 2.75 g | 2,2,3,3,4,4,5,5,6,6,7,7,8,8,8-Pentadeca-fluoroctan-1-ol 12.2 g | Desmorapid Z 0.02 g | 70 °C | farbloser Feststoff | 1.3900 (C) |
| **64** | 2,2,3,3,4,4,5,5,6,6,7,7,8,8,8-Pentadecafluoroctyl-propan-2-ylcarbamat | i-Propylisocyanat 2.63 g | 2,2,3,3,4,4,5,5,6,6,7,7,8,8,8-Pentadeca-fluoroctan-1-ol 12.4 g | Desmorapid Z 0.02 g | 70 °C | farbloser Feststoff | 1.4550 (A) |
| **65** | 2,2,3,3,4,4,5,5,6,6,7,7,8,8,8-Pentadecafluoroctyl-cyclohexylcarbamat | Cyclohexylisocyanat 3.57 g | 2,2,3,3,4,4,5,5,6,6,7,7,8,8,8-Peritadeca-fluoroctan-1-ol 11.4 g | Desmorapid Z 0.02 g | 70 °C | farbloser Feststoff | n.b. |
| **66** | 2,2,3,4,4,4-Hexafluorbutyl-butylcarbamat | n-Butylisocyanat 5.28 g | 2,2,3,4,4,4-Hexaflu-orobutan-1-ol 9.71 g | Desmorapid Z 0.02 g | 70 °C. | farblose Flüssigkeit | 1.3775 (B) |
| **67** | Bis(2,2,3,4,4,4-hexafluorbutyl)-[4-({[(2,2,3,4,4,4-hexafluorbuto-xy)carbonyl] amino}methyl)octan-1,8-diyl]biscarbamat | 1,8-Diisocyanato-4-(iso-cyanatomethyl)octan (TIN) 4.73 g | 2,2,3,4,4,4-Hexafluorobutan-1-ol 10.3 g | Desmorapid Z 0.02 g | 70 °C | farbloses Öl | 1.4180 (A) |
| **68** | Bis(2,2,3,4,4,4-hexafluorbutyl)-(2,2,4-triinethylhexan-1,6-diyl)biscarbainat | 2,4,4-Trimethylhexane-1,6-diisocyanat (TMDI) 5.48 g | 2,2,3,4,4,4-Hexafluorobutan-1-ol 9.50 g | Desmorapid Z 0.02 g | 70 °C | farbloses Öl | 1.4250 (A) |
| **69** | Bis(2,2,3,4,4,4-hexafluorbutyl)-hexan-1,6-diylbiscarbamat | 6-Diisocyanatohexan (HDI) 4.73 g | 2,2,3,4,4,4-Hexaflu-orobutan-1-ol 10.3 g | Desmorapid Z 0.02 g | 70 °C | farbloser Feststoff | 1.4760 (A) |
| **70** | Bis(2,2,3,4,4,4-hexafluorbutyl)-(methandiyldicyclohexan-4,1-diyl)biscarbamat | Dicyclohexylmethan-diisocyanat (Desmodur W) 6.27 g | 2,2,3,4,4,4-Hexaflu-orobutan-1-ol 8.27 g | Desmorapid Z 0.02 g | 70 °C | farbloser Feststoff | 1.4324 (C) |
| **71** | 2,2,3,4,4,4-Hexafluorbutyl-[3-({[(2,2,3,4,4,4-hexafluorbutoxy)carbonyl] amino} methyl)-3,5, 5-trimethylcyclohexyl] carbamat | 1-Isocyanato-3,3,5-trimethyl-5-isocyanatomethylcyclohexan (IPDI) 5.67 g | 2,2,3,4,4,4-Hexafluorobutan-1-ol 9.31 g | Desmorapid Z 0.02 g | 70 °C | farbloses Öl | 1.4300 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **72** | 2,2,3,4,4,4-Hexafluorbutyl-hexylcarbamat | n-Hexylisocyanat 6.16 g | 2,2,3,4,4,4-Hexafluorobutan-1-ol 8.83 g | Desmorapid Z 0.02 g | 70 °C | farblose Flüssigkeit | 1.3876 (B) |
| **73** | Bis(2,2,3,4,4,4-hexafluorbutyl)-(4-methylcyclohexan-1,3-diyl)biscarbamat | Hexahydrotoluylendiisocyanat (H6TDI) 4.96 g | 2,2,3,4,4,4-Hexafluorobutan-1-ol 10.0 g | Desmorapid Z 0.02 g | 70 °C | farbloser Feststoff | 1.4350 (A) |
| **74** | 2,2,3,4,4,4-Hexafluorbutyl-propan-2-ylcarbamat | i-Propylisocyanat 4.77 g | 2,2,3,4,4,4-Hexafluorobutan-1-ol 10.2 g | Desmorapid Z 0.02 g | 70°C | farbloses Öl | 1.3810 (A) |
| **75** | 2,2,3,4,4,4-Hexafluorbutyl-cyclohexylcarbamat | Cyclohexylisocyanat 6.10 g | 2,2,3,4,4,4-Hexafluorobutan-1-ol 8.88 g | Desmorapid Z 0.02 g | 70 °C | farbloser Feststoff | 1.4220 (A) |
| **76** | 2,2,3,3,4,4,5,5-Octafluorpentyl-butylcarbamat | n-Butylisocyanat 4.48 g | 2,2,3,3,4,4,5,5-Octafluorpentan-1-ol 10.5 g | Desmorapid Z 0.02 g | 70 °C | farblose Flüssigkeit | 1.3731 (B) |
| **77** | Bis(2,2,3,3,4,4,5,5-octafluorpentyl)-{4-[({[(2,2,3,3,4,4,5,5-octafluorpen-tyl)oxy] carbonyl}amino)methyl]octan-1,8-diyl} biscarbamat | 1,8-Diisocyanato-4-(iso-cyanatomethyl)octan (TIN) 3.98 g | 2,2,3,3,4,4,5,5-Octafluorpentan-1-ol 11.0 g | Desmorapid Z 0.02 g | 70 °C | farbloses Öl | 1.4100 (A) |
| **78** | Bis(2,2,3,3,4,4,5,5-octafluorpentyl)-(2,2,4-trimethythexan-1,6-diyl)biscarbamat | 2,4,4-Trimethylhexane-1,6-diisocyanat (TMDI) 4.67 g | 2,2,3,3,4,4,5,5-Octafluorpentan-1-ol 10.3 g | Desmorapid Z 0.02 g | 70 °C | farbloses Öl | 1.4160 (A) |
| **79** | Bis(2,2,3,3,4,4,5,5-octafluorpentyl)-hexan-1,6-diylbiscarbamat | 6-Diisocyanatohexan (HDI) 3.98 g | 2,2,3,3,4,4,5,5-Octafluorpentan-1-ol 11.0 g | Desmorapid Z 0.02 g | 70 °C | farbloser Feststoff | 1.4026 (C) |
| **80** | Bis(2,2,3,3,4,4,5,5-octafluorpentyl)-(methandiyldicyclohexan-4,1-diyl)biscarbamat | Dicyclohexyl-methan-diisocyanat (Desmodur W) 5.41g | 2,2,3,3,4,4,5,5-Octafluotpentan-1-ol 9.58 g | Desmorapid Z 0.02 g | 70 °C | farbloser Feststoff | 1.4350 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **81** | 2,2,3,3,4,4,5,5-Octafluorpentyl-{[1,3,3-trimethyl-5-({[(2,2,3,3,4,4,5,5-octafluorpentyl)oxy] carbonyl} amino)-cyclohexyl]methyl}carbamat | 1 Isocyanato-3,3,5-trimethyl-5-isocyanatomethylcyclohexan (IPDI) 4.85 g | 2,2,3,3,4,4,5,5-Octafluorpentan-1-ol 10.1 g | Desmorapid Z 0.02 g | 70 °C | farbloses Öl | 1.4230 (A) |
| **82** | 2,2,3,3,4,4,5,5-Octafluorpentyl-hexylcarbamat | n-Hexylisocyanat 5.30 g | 2,2,3,3,4,4,5,5-Octafluorpentan-1-ol 9.69 g | Desmorapid Z 0.02 g | 70 °C | farblose Flüssigkeit | 1.3823 (B) |
| **83** | Bis(2,2,3,3,4,4,5,5-octafluorpentyl)-(4-methylcyclohexan-1,3-diyl)biscarbamat | Hexahydrotoluylendiisocyanat (H6TDI) 4.19 g | 2,2,3,3,4,4,5,5-Octafluorpentan-1-ol 10.8 g | Desmorapid Z 0.02 g | 70 °C | farbloses Öl | 1.4120 (A) |
| **84** | 2,2,3,3,4,4,5,5-Octafluorpentyl-propan-2-ylcarbamat | i-Propylisocyanat 4.02 g | 2,2,3,3,4,4,5,5-Octafluorpentan-1-ol 10.9 g | Desmorapid Z 0.02 g | 70 °C | farblose Flüssigkeit | 1.3654 (B) |
| **85** | 2,2,3,3,4,4,5,5-Octafluorpentyl-cyclohexylcarbamat | Cyclohexylisocyanat 5.25 g | 2,2,3,3,4,4,5,5-Octafluorpentan-1-ol 9.73 g | Desmorapid Z 0.02 g | 70 °C | farblose Flüssigkeit | 1.3977 (B) |
| **86** | 2,2,3,3,4,4,5,5,6,6,7,7,7-Tridecafluorheptyl-butylcarbamat | n-Butylisocyanat 3.30 g | 2,2,3,3,4,4,5,5,6,6,7,7,7-Tridecafluorheptan-1-ol 11.7 g | Desmorapid Z 0.02 g | 70 °C | farblose Flüssigkeit | 1.3507 (B) |
| **87** | Bis(2,2,3,3,4,4,5,5,6,6,7,7,7-tridecafluorheptyl)-{4-[({[(2,2,3,3,4,4,5,5,6,6,7,7,7-tridecafluorheptyl)oxy]carbonyl}-amino) inethyl]octan-1,8-diyl}biscarbamat | 1,8-Diisocyanato-4-(isocyanatomethyl)octan (TIN) 2.90 g | 2,2,3,3,4,4,5,5,6,6,7,7,7-Tridecafluorheptan-1-ol 12.1 g | Desmorapid Z 0.02 g | 70 °C | farbloses Öl | 1.3858 (C) |
| **88** | Bis(2,2,3,3,4,4,5,5,6,6,7,7,7-tridecafluorheptyl)-(2,2,4-trimethylhexan-1,6-diyl)biscarbamat | 2,4,4-Trimethylhexane-1,6-diisocyanat (TMDI) 3.45 g | 2,2,3,3,4,4,5,5,6,6,7,7,7-Tridecafluorheptan-1-ol 11.5 g | Desmorapid Z 0.02 g | 70 °C | farbloses Öl | 1.3700 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **89** | Bis(2,2,3,3,4,4,5,5,6,6,7,7,7-tridecafluorheptyl)-hexan-1,6-diylbiscarbamat | 6-Diisocyanato-hexan (HDI) 2.90 g | 2,2,3,3,4,4,5,5,6,6,7,7,7-Tridecafluorheptan-1-ol 12.1 g | Desmorapid Z 0.02 g | 70°C | farbloser Feststoff | 1.4002 (C) |
| **90** | Bis(2,2,3,3,4,4,5,5,6,6,7,7,7-tridecafluorheptyl)-(methandiyldicyclohexan-4,1-diyl)biscarbamat | Dicyclohexyl-methan-düsocyanat (Desmodur W) 4.08 g | 2,2,3,3,4,4,5,5,6,6,7,7,7-Tridecafluorheptan-1-ol 10.9 g | Desmorapid Z 0.02 g | 70°C | farbloser Feststoff | 1.3976 (C) |
| **91** | 2,2,3,3,4,4,5,5,6,6,7,7,7-Tridecafluorheptyl-{[1,3,3 -trimethyl-5-({[(2,2,3,3,4,4,5,5,6,6,7,7,7-tridecafluorheptyl)oxy] carbonyl amino)-cyclohexyl]methyl} carbamat | 1-Isocyanato-3,3,5-trimethyl-5-isocyanatomethyl-cyclohexan (IPDI) 3.60 g | 2,2,3,3,4,4,5,5,6,6,7,7,7-Tridecafluorheptan-1-ol 11.4 g | Desmorapid Z 0.02 g | 70 °C | farbloser Feststoff | 1.3894 (C) |
| **92** | 2,2,3,3,4,4,5,5,6,6,7,7,7-Tridecafluorheptyl-hexylcarbamat | n-Hexylisocyanat 3.98 g | 2,2,3,3,4,4,5,5,6,6,7,7,7-Tridecafluorheptan-1-ol 11.0 g | Desmorapid Z 0.02 g | 70 °C | farbloser Feststoff | 1.4058 (C) |
| **93** | Bis(2,2,3,3,4,4,5,5,6,6,7,7,7-tridecafluorheptyl)-(4-methylcyclohexan-1,3-diyl)biscarbamat | Hexahydrotoluylendiisocyanat (H6TDI) 3.07 g | 2,2,3,3,4,4,5,5,6,6,7,7,7-Tridecafluorheptan-1-ol 11.9 g | Desmorapid Z 0.02 g | 70 °C | farbloser Feststoff | 1.4002 (C) |
| **94** | 2,2,3,3,4,4,5,5,6,6,7,7,7-Tridecafluorheptyl-propan-2-ylcarbamat | i-Propylisocyanat 2.93 g | 2,2,3,3,4,4,5,5,6,6,7,7,7-Tridecafluorheptan-1-ol 12.1 g | Desmorapid Z 0.02 g | 70 °C | farblose Flüssigkeit | 1.3459 (B) |
| **95** | 2,2,3,3,4,4,5,5,6,6,7,7,7-Tridecafluorheptylcyclohexylcarbamat | Cyclohexylisocyanat 3.95 g | 2,2,3,3,4,4,5,5,6,6,7,7,7-Tridecafluorheptan-1-ol 11.0 g | Desmorapid Z 0.02 g | 70 °C | farbloser Feststoff | 1.3856 (C) |
| **96** | 2,2,3,3,4,4,5,5,6,6,7,7,8,8,9,9,10,10,11,11-Icosafluorundecyl-butylcarbamat | n-Butylisocyanat 2.35 g | 2,2,3,3,4,4,5,5,6,6,7,7,8,8,9,9,10,10,11,11-Icosafluorundecan-1-ol 12.6 | Desmorapid Z 0.02 g | 70 °C | farbloser Feststoff | 1.3700 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **97** | Bis(2,2,3,3,4,4,5,5,6,6,7,7,8,8,9,9,10,10,11,11-icosafluorundecyl)- {4-[({[(2,2,3,3,4,4,5,5,6,6,-7,7,8,8,9,9,10,10,11,11-icosafluorundecyl)oxy]carbonyl}-amino) methyl]octan-1,8-diyl}biscarbamat | 1,8-DÜsocyanato-4-(iso-cyanatomethyl)octan (TIN) 2.04 g | 2,2,3,3,4,4,5,5,6,6,7,7 8,8,9,9,10,10,11,11-Icosafluorundecan-1-ol 12.9 g | Desmorapid Z 0.02 g | 70 °C | farbloser Feststoff | 1.3750 (A) |
| **98** | Bis(2,2,3,3,4,4,5,5,6,6,7,7,8,8,9,9,10,10,11,11-icosafluorundecyl)-(2,2,4-trimethylhexan-1,6-diyl)biscarbamat | 2,4,4-Trimethylhexane-1,6-diisocyanat (TMDI) 2.46 g | 2,2,3,3,4,4,5,5,6,6,7,7,8,8,9,9,10,10,11,11-Icosafluorundecan-1-ol 12.5 g | Desmorapid Z 0.02 g | 70 °C | farbloser Feststoff | 1.4000 (A) |
| **99** | Bis(2,2,3,3,4,4,5,5,6,6,7,7,8,8,9,9,10,10 ,11,11-icosafluorundecyl)-hexan-1,6-diylbiscarbamat | 6-Diisocyanatohexan (HDI) 2.04 g | 2,2,3,3,4,4,5,5,6,6,7,7,8,8,9,9,10,10,11,11-Icosafluorundecan-1-ol 12.9 g | Desmorapid Z 0.02 g | 70 °C | farbloser Feststoff | n.b. |
| **100** | Bis(2,2,3,3,4,4,5,5,6,6,7,7,8,8,9,9,10,10,11,11-icosafluorundecyl)-(methandiyldicyclohexan-4,1-diyl)biscarbamat | Dicyclohexylmethan-diisocyanat (Desmodur W) 2.96 g | 2,2,3,3,4,4,5,5,6,6,7,7,8,8,9,9,10,10,11,11-Icosafluorundecan-1-ol 12.0 g | Desmorapid Z 0.02 g | 70 °C | farbloser Feststoff | 1.3930 (C) |
| **101** | 2,2,3,3,4,4,5,5,6,6,7,7,8,8,9,9,10,10,11,11-Icosafluorundecyl-{3-[({[(2,2,3,3,4,4,5,5,6,6-,7,7,8,8,9,9,10,10,11,11-icosafluorundecyl)oxy]-carbonyl}amino) methyl]-3,5,5-trimethylcyclohexyl} carbamat | 1-Isocyanato-3,3,5-trimethyl-5-isocyanatomethylcyclohexan (IPDI) 2.58 g | 2,2,3,3,4,4,5,5,6,6,7,7,8,8,9,9,10,10,11,11-Icosafluorundecan-1-ol 12.4 g | Desmorapid Z 0.02 g | 70 °C | farbloser Feststoff | 1.3950 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **102** | 2,2,3,3,4,4,5,5,6,6,7,7,8,8,9,9,10,10,11,11-Icosafluorundecyl-hexylcarbamat | n-Hexylisocyanat 2.88 g | 2,2,3,3,4,4,5,5,6,6,7,7,8, 8,9,9,10,10,11,11-Icosafluorundecan-1-ol 12.1 g | Desmorapid Z 0.02 g | 70 °C | farbloser Feststoff | 1.3770 (C) |
| **103** | Bis(2,2,3,3,4,4,5,5,6,6,7,7,8,8,9,9,10,10,11,11-icosafluorundecyl)-(4-methylcyclohexan-1,3-diyl)biscarbamat | Hexahydrotoluylen-diisocyanat (H6TDI) 2.17 g | 2,2,3,3,4,4,5,5,6,6,7,7,8,8,9,9,10,10,11,11-Icosafluorundecan-1-ol 12.8 g | Desmorapid Z 0.02 g | 70 °C | farbloser Feststoff | 1.3890 (C) |
| **104** | 2,2,3,3,4,4,5,5,6,6,7,7,8,8,9,9,10,10,11,11-Icosafluorundecyl-propan-2-ylcarbamat | i-Propylisocyanat 2.06 g | 2,2,3,3,4,4,5,5,6,6,7,7,8,8,9,9,10,10,11,11-Icosafluorundecan-1-ol 12.9 g | Desmorapid Z 0.02 g | 70 °C | farbloser Feststoff | 1.3700 (A) |
| **105** | 2,2,3,3,4,4,5,5,6,6,7,7,8,8,9,9,10,10,11,11 -Icosafluorundecyl-cyclohexylcarbamat | Cyclohexylisocyanat 2.85 g | 2,2,3,3,4,4,5,5,6,6,7,7,8, 8,9,9,10,10,11,11-Icosafluorundecan-1-ol 12.1 g | Desmorapid Z 0.02 g | 70 °C | farbloser Feststoff | n.b. |
| **106** | 2,2,3,3,4,4,5,5,6,6,7,7,8,8,9,9,10,10,11,11,12,12,13,13-Tetracosafluortridecyl-butylcarbamat | n-Butylisocyanat 2.03 g | 2,2,3,3,4,4,5,5,6,6,7,7,8,8,9,9,10,10,11,11,12 , 12,13,13-Tetracosafluortridecan-1-ol 12.5g | Desmorapid Z 0.02 g | 70 °C | farbloser Feststoff | 1.3796 (C) |
| **107** | Bis(2,2,3,3,4,4,5,5,6,6,7,7,8,8,9,9,10,10,11,11,12,12,13,13-tetracosafluortridecyl)-{4-[({[(2,2,3,3,4,4,5,5,6,6,7,7,8,8,9,9,10, 10,11,11,12,12,13,13-tetracosafluortridecyl)oxy] carbonyl}-amino)methyl]octan-1,8-diyl} biscarbamat | 1,8-Diisocyanato-4-(isocyanatomethyl)octan (TIN) 1.76 g | 2,2,3,3,4,4,5,5,6,6,7,7,8,8,9,9,10,10,11,11,12 , 12,13,13-Tetracosafluortridecan-1-ol 13.2 g | Desmorapid Z 0.02 g | 70 °C | farbloser Feststoff | n.b. |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **108** | Bis(2,2,3,3,4,4,5,5,6,6,7,7,8,8,9,9,10,10,11,11,12,12,13,13-tetracosafluortridecyl)-(2,2,4-trimethylhexan-1,6-diyl)biscarbamat | 2,4,4-Trimethylhexane-1,6-diisocyanat, (TMDI) 2.13 g | 2,2,3,3,4,4,5,5,6,6,7,7,8,8,9,9,10,10,11,11,12,12,13,13-Tetracosafluortridecan-1-ol 12.8 g | Desmorapid Z 0.02 g | 70 °C | farbloser Feststoff | 1.3600 (A) |
| **109** | Bis(2,2,3,3,4,4,5,5,6,6,7,7,8,8,9,9,10,10,11,11,12,12,13,13-tetracosafluortridecyl)-hexan-1,6-diylbiscarbamat | 6-Diisocyanatohexan (HDI) 1.76 g | 2,2,3,3,4,4,5,5,6,6,7,7,8,8,9,9,10,10,11,11,12,12,13,13-Tetracosafluortridecan-1-ol 13.2 g | Desmorapid Z 0.02 g | 70 °C | farbloser Feststoff | n.b. |
| **110** | Bis(2,2,3,3,4,4,5,5,6,6,7,7,8,8,9,9,10,10,11,11,12,12,13,13-tetracosafluortridecyl)-(methandiyldicyclohexan-4,1-diyl)biscarbamat | Dicyclohexylmethan-diisocyanat (Desmodur W) 2.57 g | 2,2,3,3,4,4,5,5,6,6,7,7,8,8,9,9,10,10,11,11,12,12,13,13-Tetracosafluortridecan-1-ol 12.4 g | Desmorapid Z 0.02 g | 70 °C | farbloser Feststoff | n.b. |
| **111** | 2,2,3,3,4,4,5,5,6,6,7,7,8,8,9,9,10,10,11,11,12,12,13,13-Tetracosafluortridecyl-{[1,3,3-trimethyl-5-({[(2,2,3,3,4,4,5,5,6,6,7,7,8,8,9,9,10,10,11,11,12,12,13,13-tetracosafluortridecyl)oxy]carbonyl}-amino)cyclohexyl]methyl}carbamat | 1-Isocyanato-3,3,5-trimethyl-5-isocyanatomethylcyclohexan (IPDI) 2.24 g | 2,2,3,3,4,4,5,5,6,6,7,7,8,8,9,9,10,10,11,11,12,12,13,13-Tetracosafluortridecan-1-ol 12.8 g | Desmorapid Z 0.02 g | 70 °C | farbloser Feststoff | 1.3934 (C) |
| **112** | 2,2,3,3,4,4,5,5,6,6,7,7,8,8,9,9,10,10,11,11,12,12,13,13-Tetracosafluortridecyl-hexylcarbamat | n-Hexylisocyanat 2.5 1 g | 2,2,3,3,4,4,5,5,6,6,7,7,8,8,9,9,10,10,11,11,12,12,13,13-Tetracosafluortridecan-1-ol 12.5 g | Desmorapid Z 0.02 g | 70 °C | farbloser Feststoff | 1.3742 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **113** | Bis(2,2,3,3,4,4,5,5,6,6,7,7,8,8,9,9,10,10,11,11,12,12,13,13-tetracosafluortridecyl)-(4-methylcyclohexan-1,3-diyl)biscarbamat | Hexahydrotoluylendiisocyanat (H6TDI) 1.86 g | 2,2,3,3,4,4,5,5,6,6,7,7,8,8,9,9,10,10,11,11,12,12,13,13-Tetracosafluortridecan-1-ol 13.1 g | Desmorapid Z 0.02 g | 70 °C | farbloser Feststoff | n.b. |
| **114** | 2,2,3,3,4,4,5,5,6,6,7,7,8,8,9,9,10,10,11,11,12,12,13,13-Tetracosafluortridecyl-propan-2-ylcarbamat | i-Propylisocyanat 1.78 g | 2,2,3,3,4,4,5,5,6,6,7,7,8,8,9,9,10,10,11,11,12,12,13,13-Tetracosafluortridecan-1-ol 13.2 g | Desmorapid Z 0.02 g | 70 °C | farbloser Feststoff | 1.3716 (C) |
| **115** | 2,2,3,3,4,4,5,5,6,6,7,7,8,8,9,9,10,10,11,11,12,12,13,13-Tetracosafluortridecyl-cyclohexylcarbamat | Cyclohexylisocyanat 2.48 g | 2,2,3,3,4,4,5,5,6,6,7,7,8,8,9,9,10,10,11,11,12,12,13,13-Tetracosafluortridecan-1-ol 12.5 g | Desmorapid Z 0.02 g | 70 °C | farbloser Feststoff | n.b. |
| **116** | Bis(2,2,3,3-tetrafluorpropyl)-[4-({[(2,2,3,3-tetrafluorpropoxy)carbonyl] amino}methyl)octan-1,8-diyl]biscarbamat | 1,8-Diisocyanato-4-(isocyanatometlryl)octan (TIN) 5.83 g | 2,2,3,3-Tetrafluor-1-propanol 9.16 g | Desmorapid Z 0.02 g | 70 °C | farbloses Öl | 1.4300 (A) |
| **117** | Bis(2,2,3,3-tetrafluorpropyl)-(2,2,4-trimethylhexan-1,6-diyl)biscarbamat | 2,4,4-Trimethylhexane-1,6-diisocyanat, (TMDI) 6.64 g | 2,2,3,3-Tetrafluor-1-propanol 8.35 g | Desmorapid Z 0.02 g | 70 °C | farblose Flüssigkeit | 1.4320 (A) |
| **118** | Bis(2,2,2-trifluorethyl)-hexan-1,6-diylbiscarbamat | 6-Diisocyanatohexan (HDI) 6.84 g | 1,1,1-Trifluorethanol 8.14 g | Desmorapid Z 0.02 g | 70 °C | farbloser Feststoff | 1.4178 (C) |
| **119** | Bis(2,2,3,3-tetrafluorpropyl)-hexan-1,6-diylbiscarbamat | 6-Diisocyanatohexan (HDI) 5.83 g | 2,2,3,3-Tetrafluor-1-propanol 9.16 g | Desmorapid Z 0.02 g | 70 °C | farbloser Feststoff | 1.4308 (C) |
| **120** | Bis(2,2,3,3,4,4,4-heptafluorbutyl)-hexan-1,6-diylbiscarbamat | 6-Diisocyanatohexan (HDI) 4.43 g | 2,2,3,3,4,4,4-Heptafluor-1-butanol 10.6 g | Desmorapid Z 0.02 g | 70 °C | farbloser Feststoff | n.b. |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **121** | Bis(2,2,3,3,4,4,5,5,6,6,7,7,8,8,9,9-hexadecafluornonyl)-hexan-1,6-diylbiscarbamat | 6-Diisocyanatohexan (HDI) 2.44 g | 2,2,3,3,4,4,5,5,6,6,7,7,8,8,9,9-Hexadecafluornonanol 12.5 g | Desmorapid Z 0.02 g | 70 °C | farbloser Feststoff | n.b. |
| **122** | Bis(2,2,2-trifluorethyl)-(methandiyldicyclohexan-4,1-diyl)biscarbamat | Dicyclohexylmethan-diisocyanat (Desmodur W) 8.50 g | 2,2,2-Trifluorethanol 6.49 g | Desmorapid Z 0.02 g | 70 °C | farbloser Feststoff | 1.4600 (A) |
| **123** | Bis(1,1,1,3,3,3-hexafluorpropan-2-yl)-(methandiyldicyclohexan-4,1-diyl) biscarbamat | Dicyclohexylmethan-diisocyanat (Desmodur W) 6.57 g | 1,1,1,3,3,3-Hexafluorpropan-2-ol 8,42 g | Desmorapid Z 0.02 g | 70 °C | farbloser Feststoff | 1.4300 (A) |
| **124** | Bis(2,2,3,3-tetrafluorpropyl)-(methandiyldicyclohexan-4,1-diyl)biscarbamat | Dicyclohexylmethan-diisocyanat (Desmodur W) 7.46 g | 2,2,3,3-Tetrafluorpropan-1-ol 7.52 g | Desmorapid Z 0.02 g | 70 °C | farbloser Feststoff | 1.4500 (A) |
| **125** | Bis(2,2,3,3,4,4,4-heptafluorbutyl)-(methandiyldicyclohexan-4,1-diyl)biscarbamat | Dicyclohexylmethan-diisocyanat (Desmodur W) 5.93 g | 2,2,3,3,4,4,4-Heptafluorbutan-1-ol 9.05 g | Desmorapid Z 0.02 g | 70 °C | farbloser Feststoff | 1.4312 (C) |
| **126** | Bis(2,2,3,3,4,4,5,5,6,6,7,7,8,8,9,9-hexadecafluornonyl)-(methandiyldicyclohexan-4,1-diyl)biscarbamat | Dicyclohexylmethan-diisocyanat (Desmodur W) 3.48 g | 2,2,3,3,4,4,5,5,6,6,7,7,8,8,9,9-Hexadecafluornonan-1-ol 11.5 g | Desmorapid Z 0.02 g | 70 °C | farbloser Feststoff | 1.4100 (A) |
| **127** | 2,2,2-Trifluorethyl-[(1,3,3-trimethyl-5-{[(2,2,2-trifluorethoxy)carbonyl] amino}-cyclohexyl)methyl]carbamat | 1-Isocyanato-3,3,5-trimethyl-5-isocyanatomethylcyclohexan (IPDI) 7.88 g | 2,2,2-Trifluorethanol 7.10 g | Desmorapid Z 0.02 g | 70 °C | farbloses Öl | 1.4400 (A) |
| **128** | 1,1,1,3,3,3-Hexafluorpropan-2-yl-{3-[({[(1,1,1,3,3,3-hexafluorpropan-2-yl)oxy] carbonyl}amino)methyl]-3,5,5-trimethylcyclohexyl}carbamat | 1-Isocyanato-3,3,5-trimethyl-5-isocyanatomethyl-cyclohexan (IPDI) 5.96 g | 1,1,1,3,3,3-Hexafluorpropan-2-ol 9.02 g | Desmorapid Z 0.02 g | 70 °C | farbloser Feststoff | 1.4100 (A) |
| **129** | 2,2,3,3-Tetrafluorpropyl-[(1,3,3-trimethyl-5-{[(2,2,3,3-tetrafluorpropoxy)carbonyl] amino}-cyclohexyl)methyl]carbamat | 1-Isocyanato-3,3,5-trimethyl-5-isocyanatomethyl-cyclohexan (IPDI) 6.85 g | 2,2,3,3-Tetrafluorpropan-1-ol 8.13 g | Desmorapid Z 0.02 g | 70 °C | farbloses Öl | 1.4394 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **130** | 2,2,3,3,4,4,4-Heptafluorbutyl-[3-({[(2,2,3,3,4,4,4-heptafluorbutoxy)carbonyl]amino}methyl)-3,5,5-trimethylcyclohexyl]carbamat | 1-Isocyanato-3,3,5-trimethyl-5-isocyanatomethylcyclohexan (IPDI) 5.35 g | 2,2,3,3,4,4,4-Heptafluorbutan-1-ol 9.63 g | Desmorapid Z 0.02 g | 70 °C | farbloser Feststoff | 1.4092 (C) |
| **131** | 2,2,3,3,4,4,5,5,6,6,7,7,8,8,9,9-Hexadecafluornonyl-{3-[({[(2,2,3,3,4,4,5,5,6,6, 7,7,8,8,9,9-hexadecafluornonyl)oxy]carbonyl}-amino)methyl]-3,5,5-trimethylcyclohexyl}carbamat | 1-Isocyanato-3,3,5-trimethyl-5-isocyanatomethylcyclohexan (IPDI) 3.06 g | 2,2,3,3,4,4,5,5,6,6,7,7,8,8,9,9-Hexadecafluornonan-1-ol 11.9 g | Desmorapid Z 0.02 g | 70 °C | farbloser Feststoff | 1.4050 (A) |
| **132** | 2,2,3,3,4,4,4-Heptafluorbutyl-hexylcarbamat | n-Hexylisocyanat 5.82 g | 2,2,3,3,4,4,4-Heptafluorbutan-1-ol 9.16 g | Desmorapid Z 0.02 g | 70 °C | farblose Flüssigkeit | 1.3745 (B) |
| **133** | 2,2,3,3,4,4,5,5,6,6,7,7,8,8,9,9-Hexadecafluornonyl-hexylcarbamat | n-Hexylisocyanat 3.40 g | 2,2,3,3,4,4,5,5,6,6,7,7,8,8,9,9-Hexadecafluornonan-1-ol 11.6 g | Desmorapid Z 0.02 g | 70 °C | farbloser Feststoff | 1.4030 (A) |
| **134** | Bis(2,2,2-trifluorethyl)-(4-methylcyclohexan-1,3-diyl)biscarbamat | Hexahydrotoluylen-diisocyanat (H6TDI) 7.10 g | 2,2,2-Trifluorethanol 7.88 g | Desmorapid Z 0.02 g | 70 °C | farbloser Feststoff | 1.4334 (C) |
| **135** | Bis(1,1,1,3,3,3-hexafluorpropan-2-yl)-(4-methylcyclohexan-1,3-diyl)biscarbamat | Hexahydrotoluylendiisocyanat (H6TDI) 5.23 g | 1,1,1,3,3,3-Hexafluorpropan-2-ol 9.76 g | Desmorapid Z 0.02 g | 70 °C | farbloser Feststoff | 1.4032 (C) |
| **136** | Bis(2,2,3,3-tetrafluorpropyl)-(4-methylcyclohexan-1,3-diyl)biscarbamat | Hexahydrotoluylendiisocyanat (H6TDI) 6.08 g | 2,2,3,3-Tetrafluorpropan-1-ol 8.90 g | Desmorapid Z 0.02 g | 70 °C | farbloser Feststoff | 1.4340 (C) |
| **137** | Bis(2,2,3,3,4,4,4-heptafluorbutyl)-(4-methylcyclohexan-1,3-diyl)biscarbamat | Hexahydrotoluylendiisocyanat (H6TDI) 4.65 g | 2,2,3,3,4,4,4-Heptafluorbutan-1-ol 11.3 g | Desmorapid Z 0.02 g | 70 °C | farbloser Feststoff | 1.4022 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **138** | Bis(2,2,3,3,4,4,5,5,6,6,7,7,8,8,9,9-hexadecafluornonyl)-(4-methylcyclohexan-1,3-diyl)biscarbamat | Hexahydrotoluylendiisocyanat (H6TDI) 2.58 g | 2,2,3,3,4,4,5,5,6,6,7,7,8,8,9,9-Hexadecafluornonan-1-ol 12.4 g | Desmorapid Z 0.02 g | 70 °C | farbloser Feststoff | 1.3878 (C) |
| **139** | 1,1,1,3,3,3-Hexafluorpropan-2-yl-propan-2-ylcarbamat | i-Propylisocyanat 5.04 g | 1,1,1,3,3,3-Hexafluorpropan-2-ol 9.94 g | Desmorapid Z 0.02 g | 70 °C | gelber Feststoff | 1.3542 (C) |
| **140** | 2,2,3,3-Tetrafluorpropyl-propan-2-ylcarbamat | i-Propylisocyanat 5.87 g | 2,2,3,3-Tetrafluorpropan-1-ol 9.11 g | Desmorapid Z 0.02 g | 70 °C | farblose Flüssigkeit | 1.3831 (B) |
| **141** | 2,2,3,3,4,4,4-Heptafluorbutyl-propan-2-ylcarbamat | i-Propylisocyanat 4.47 g | 2,2,3,3,4,4,4-Heptafluorbutan-1-ol 10.5 g | Desmorapid Z 0.02 g | 70 °C | farblose Flüssigkeit | 1.3526 (B) |
| **142** | 2,2,3,3,4,4,5,5,6,6,7,7,8,8,9,9-Hexadecafluomonyl-propan-2-ylcarbamat | i-Propylisocyanat 2.48 g | 2,2,3,3,4,4,5,5,6,6,7,7,8,8,9,9-Hexadecafluornonan-1-ol 12.5 g | Desmorapid Z 0.02 g | 70 °C | farbloses Öl | 1.3600 (A) |
| **143** | 2,2,2-Trifluorethyl-cyclohexylcarbamat | Cyclohexylisocyanat 8.33 g | 2,2,2-Trifluorethanol 6.65 g | Desmorapid Z 0.02 g | 70 °C | farbloser Feststoff | 1.4256 (C) |
| **144** | 1,1,1,3,3,3-Hexafluorpropan-2-yl-cyclohexylcarbamat | Cyclohexylisocyanat 6.40 g | 1,1,1,3,3,3-Hexafluorpropan-2-ol 8.58 g | Desmorapid Z 0.02 g | 70 °C | farbloser Feststoff | 1.4020 (C) |
| **145** | 2,2,3,3-Tetrafluorpropylcyclohexylcarbamat | Cyclohexylisocyanat 7.29 g | 2,2,3,3-Tetrafluorpropan-1-ol 7.69 g | Desmorapid Z 0.02 g | 70 °C | farbloser Feststoff | 1.4296 (C) |
| **146** | 2,2,3,3,4,4,4-Heptafluorbutyl-cyclohexylcarbamat | Cyclohexylisocyanat 5.77 g | 2,2,3,3,4,4,4-Heptafluorbutan-1-ol 9.21 g | Desmorapid Z 0.02 g | 70 °C | farbloser Feststoff | n.b. |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **147** | 2,2,3,3,4,4,5,5,6,6,7,7,8,8,9,9-Hexadecafluornonyl-cyclohexylcarbamat | Cyclohexylisocyanat 3.37 g | 2,2,3,3,4,4,5,5,6,6,7,7,8,8,9,9-Hexadecafluornonan-1-ol 11.6 g | Desmorapid Z 0.02 g | 70 °C | farbloser Feststoff | 1.3930 (A) |
| **148** | 2,2,3,3,4,4,5,5,6,6,7,7-Dodecafluoroctan-1,8-diyl-bis(butylcarbamat) | n-Butylisocyanat 7.07 g | 2,2,3,3,4,4,5,5,6,6,7,7-Dodecafluoroctan-1,8-diol 10.9 g | Desmorapid Z 0.01 g | 60 °C | farbloser Feststoff | n.b. |
| **149** | 2,2,3,3,4,4,5,5,6,6,7,7-Dodecafluoroctan-1,8-diyl-bis(hexylcarbamat) | n-Hexylisocyanat 6.18 g | 2,2,3,3,4,4,5,5,6,6,7,7-Dodecafluoroctan-1,8-diol 8.80 g | Desmorapid Z 0.02 g | 70 °C | farbloser Feststoff | 1.4000 (A) |
| **150** | 2,2,3,3,4,4,5,5,6,6,7,7-Dodecafluoroctan-1,8-diyl-bis(propan-2-ylcarbamat) | i-Propylisocyanat 4.79 g | 2,2,3,3,4,4,5,5,6,6,7,7-Dodecafluoroctan-1,8-diol 10.2 g | Desmorapid Z 0.02 g | 70 °C | farbloser Feststoff | 1.4000 (A) |
| **151** | 2,2,3,3,4,4,5,5,6,6,7,7-Dodecafluoroctan-1,8-diyl-bis[(1-methylcyclohexyl) carbamat] | Cyclohexylisocyanat 6.13 g | 2,2,3,3,4,4,5,5,6,6,7,7-Dodecafluoroctan-1,8-diol 8.85 g | Desmorapid Z 0.02 g | 70 °C | farbloser Feststoff | n.b. |
| **152** | 4,4,5,5,6,6,7,7,8,8,9,9,1 0,10,11,11,11-Heptadecafluorundecan-1,2-diyl-bis (butylcarbamat) | n-Butylisocyanat 4.28 g | 4,4,5,5,6,6,7,7,8,8,9,9,10,10,11,11,11-Heptadecafluoro-1,2-undecanediol 10, 7 g | Desmorapid Z 0.02 g | 70 °C | farbloser Feststoff | 1.4038 (C) |
| **153** | 4,4,5,5,6,6,7,7,8,8,9,9,10,10,11,11,11-Heptadecafluorundecan-1,2-diyl-bis (hexylcarbamat) | n-Hexylisocyanat 5.08 g | 4,4,5,5,6,6,7,7,8,8,9,9,10,10,11,11,11-Heptadecafluoro-1,2-undecanediol 9.90 g | Desmorapid Z 0.02 g | 70 °C | farbloser Feststoff | 1.3988 (C) |
| **154** | 4,4,5,5,6,6,7,7,8,8,9,9,1 0,10,11,11,11-Heptadecafluorundecan-1,2-diyl-bis (propan-2-ylcarbamat) | i-Propylisocyanat 3.84 g | 4,4,5,5,6,6,7,7,8,8,9,9,10,10,11,11,11-Heptadecafluoro-1,2-undecanediol 11.1 g | Desmorapid Z 0.02 g | 70 °C | farbloser Feststoff | n.b. |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **155** | 4,4,5,5,6,6,7,7,8,8,9,9,10,10,11,11,11-Heptadecafluorundecan-1,2-diyl-bis (cyclohexylcarbamat) | Cyclohexylisocyanat 5.04 g | 4,4,5,5,6,6,7,7,8,8,9,9,10,10,11,11,11-Heptadecafluoro-1,2-undecanediol 9.94 g | Desmorapid Z 0.02 g | 70 °C | farbloser Feststoff | n.b. |
| **156** | 2,2,3,3,4,4,5,5-Octafluorhexan-1,6-diyl-bis(butylcarbamat) | n-Butylisocyanat 6.44 g | 2,2,3,3,4,4,5,5-Octafluorohexane-1,6-diol 8.54 g | Desmorapid Z 0.02 g | 70 °C | farbloser Feststoff | 1.4226 (C) |
| **157** | 2,2,3,3,4,4,5,5-Octafluorhexan-1,6-diyl-bis(hexylcarbamat) | n-Hexylisocyanat 7.38 g | 2,2,3,3,4,4,5,5-Octafluorohexane-1,6-diol 7.60 g | Desmorapid Z 0.02 g | 70 °C | farbloser Feststoff | n.b. |
| **158** | 2,2,3,3,4,4,5,5-Octafluorhexan-1,6-diyl-bis(propan-2-ylcarbamat) | i-Propylisocyanat 5.90 g | 2,2,3,3,4,4,5,5-Octafluorohexane-1,6-diol 9.08 g | Desmorapid Z 0.02 g | 70 °C | farbloser Feststoff | n.b. |
| **159** | 2,2,3,3,4,4,5,5-Octafluorhexan-1,6-diyl-bis(cyclohexylcarbamat) | Cyclohexylisocyanat 7.32 g | 2,2,3,3,4,4,5,5-Octafluorohexane-1,6-diol 7.66 g | Desmorapid Z 0.02 g | 70 °C | farbloser Feststoff | n.b. |
| **160** | n-Butylcarbamat des Fluorlink E 10/H | n-Butylisocyanat 1.86 g | Fluorlink E 10/H 13.1 g | Desmorapid Z 0.02 g | 70 °C | farblose Flüssigkeit | 1.3469 (B) |
| **161** | n-Hexylcarbamat des Fluorlink E 10/H | n-HeYylisocyanat 2.30 g | Fluorlink E 10/H 12.7 g | Desmorapid Z 0.02 g | 70 °C | farblose Flüssigkeit | 1.3530 (B) |
| **162** | i-Propylcarbamat des Fluorlink E 10/H | i-Propylisocyanat 1.62 g | Fluorlink E 10/H 13.4 g | Desmorapid Z 0.02 g | 70 °C | farblose Flüssigkeit | 1.3450 (A) |
| **163** | Cyclohexylcarbamat des Fluorlink E 10/H | Cyclohexylisocyanat 2.27 g | Fluorlink E 10/H 12.7 g | Desmorapid Z 0.02 g | 70 °C | farblose Flüssigkeit | n.b. |
| **164** | 1,1,1,3,3,3-Hexafluorpropan-2-yl-butylcarbamat | n-Butylisocyanat 6.96 g | 1,1,1-Trifluorpropan-2-ol 8.02 g | Desmorapid Z 0.02 g | 70 °C | farblose Flüssigkeit | 1.3912 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **165** | Bis(1,1,1,3,3,3-hexafluorpropan-2-yl)-{4-[({[(1,1,1,3,3,3-hexafluorpropan-2-yl) oxy]carbonyl}amino)methyl]octan-1,8-diyl}biscarbamat | 1,8-Diisocyanato-4-(isocyanatomethyl)octan (TIN) 6.36 g | 1,1,1 -Trifluorpropan-2-ol 8.62 g | Desmorapid Z 0.02 g | 70 °C | farbloses Öl | 1.4322 (C) |
| **166** | Bis(1,1,1,3,3,3-hexafluorpropan-2-yl)-(2,2,4-trimethylhexan-1,6-diyl) biscarbamat | 2,4,4-Trimethylhexane-1,6-diisocyanat, (TMDI) 7.18 g | 1,1,1 -Trifluorpropan-2-ol 7.80 g | Desmorapid Z 0.02 g | 70 °C | farbloses Öl | 1.4262 (B) |
| **167** | Bis(1,1,1,3,3,3-hexafluorpropan-2-yl)-hexan-1,6-diylbiscarbamat | 6-Diisocyanatohexan (HDI) 6.36 g | 1,1,1-Trifluoiprop an-2-ol 8.62 g | Desmorapid Z 0.02 g | 70 °C | farbloser Feststoff | n.b. |
| **168** | Bis(1,1,1,3,3,3-hexafluorpropan-2-yl)-(methandiyldicyclohexan-4,1-diyl) biscarbamat | Dicyclohexylmethan-diisocyanat (Desmodur W) 8.01 g | 1,1,1 -Trifluorpropan-2-ol 6.97 g | Desmorapid Z 0.02 g | 70 °C | farbloser Feststoff | n.b. |
| **169** | 1,1,1,3,3,3-Hexafluorpropan-2-yl-{3-[({[ (1,1,1,3,3,3-hexafluorpropan-2-yl)oxy] carbonyl}amino)methyl]-3,5,5-trimethylcyclohexyl} carbamat | 1-Isocyanato-3,3,5-trimethyl-5-isocyanatomethylcyclohexan (IPDI) 7.39 g | 1,1,1-Trifluorpropan-2-ol 7.59 g | Desmorapid Z 0.02 g | 70 °C | farbloses Öl | 1.4360 (C) |
| **170** | 1,1,1,3,3,3-Hexafluorpropan-2-yl-hexylcarbamat | n-Hexylisocyanat 7.90 g | 1,1,1-Trifluorpropan-2-ol 7.08 g | Desmorapid Z 0.02 g | 70 °C | farblose Flüssigkeit | 1.3996 (B) |
| **171** | Bis(1,1,1,3,3,3-hexafluorpropan-2-yl)-(4-methylcyclohexan-1,3-diyl)biscarbamat | Hexahydrotoluylendiisocyanat (H6TDI) 6.62 g | 1,1,1-Trifluorpropan-2-ol 8.36 g | Desmorapid Z 0.02 g | 70 °C | farbloser Feststoff | n.b. |
| **172** | 1,1,1,3,3,3-Hexafluorpropan-2-yl-propan-2-ylcarbamat | i-Propylisocyanat 6.40 g | 1,1,1 Trifluorpropan-2-ol 8.58 g | Desmorapid Z 0.02 g | 70 °C | farbloser Feststoff | 1.3870 (C) |
| **173** | 1,1,1,3,3,3-Hexafluorpropan-2-yl-cyclohexylcarbamat | Cyclohexylisocyanat 7.84 g | 1,1,1-Trifluorpropan-2-ol 7.14 g | Desmorapid Z 0.02 g | 70 °C | farbloser Feststoff | n.b. |
| **174** | 2-Ethylhexyl-2,2,2-trifluorethyl-hexan-1,6-diylbiscarbamat | Desmodur LD 11.6 g | 2,2,2-Trifluorethanol 3.35 g | Desmorapid Z 0.02 g | 70 °C | farbloser Feststoff | 1.4940 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **175** | alpha-(6-{[(2,2,2-Trifluorethoxy) carbonyl]-amino}hexyl)-omega-{[(2,2,2-trifluorethoxy)-carbonyl]amino}poly[(2,4-dioxo-1,3-diazetidin-1,3-diyl)hexan-1,6-diyl] | Desmodur N3400 9.86 g | 2,2,2-Trifluorethanol 5.12 g | Desmorapid Z 0.02 g | 70 °C | farbloser Feststoff | 1.4450 (A) |
| **176** | alpha-(6-{[(2,2,2-Trifluorethoxy)carbonyl] amino}-hexyl)-omega-[2,4,6-trioxo-3,5-bis(6-{[(2,2,2-trifluorethoxy)carbonyl] amino}hexyl)-1,3,5-triazinan-1-ylJpoly{[2,4,6-trioxo-5-(6-{[(2,2,2-trifluorethoxy)carbonyl]amino}hexyl)-1,3,5-triazinan-1,3-diyl]hexan-1,6-diyl} | Desmodur N3600 9.68 g | 2,2,2-Trifluorethanol 5.30 g | Desmorapid Z 0.02 g | 70 °C | farbloser Feststoff | 1.4584 (C) |
| **177** | alpha-(6- {[(2,2,2-Tnfluorethoxy)carbonyl] amino} - hexyl)-omega-{[(2,2,2-trifluorethoxy)-carbonyl]amino}poly({(6Z)-2,4-dioxo-6-[(6-{[(2,2,2-trifluorethoxy)-carbonyl]amino}hexyl) imino]-1,3,5-oxadiazinan-3,5-diyl} hexan-1,6-diyl) | Desmodur N3900 9.64 g | 2,2,2-Trifluorethanol 5.34 g | Desmorapid Z 0.02 g | 70 °C | farbloser Feststoff | 1.4200 (A) |
| **178** | alpha-(6- {[(2,2,2-Trifluorethoxy)-carbonyl]amino} hexyl)-omega-{[(2,2,2-trifluorethoxy)-carbonyl]amino} poly[(2,4,6-trioxo-1,3,5-oxadiazinan-3,5-diyl)hexan-1,6-diyl] | Baymicron OXA 10.1 g | 2,2,2-Trifluorethanol 4.90 g | Desmorapid Z 0.02 g | 70 °C | farbloser Feststoff | 1.4562 (C) |
| **179** | Bis(2,2,2-trifluorethyl)-(cyclohexan-1,3-diyldimethandiyl)biscarbamat | 1,3-Bis-(isocyanatomethyl)-cyclohexan 7.38 g | 2,2,2-Trifluorethanol 7.60 g | Desmorapid Z 0.02 g | 70 °C | farbloser Feststoff | 1.4348 (C) |
| **180** | 2-Ethylhexyl-hexafluorpropan-2-yl-hexan-1,6-diylbiscarbamat | Desmodur LD 10.1 g | Hexafluor-2-propanol 4.88 g | Desmorapid Z 0.02 g | 70 °C | farbloser Feststoff | 1.4250 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **181** | alpha-(6- {[(Hexafluorpropan-2-yl) carbonyl]amino}hexyl)-omega-{[ (hexafluorpropan-2-yl)-carbonyl]amino} poly[(2,4-dioxo-1,3-diazetidin-1,3-diyl) hexan-1,6-diyl] | Desmodur N3400 8.00 g | Hexafluor-2-propanol 6.98 g | Desmorapid Z 0.02 g | 70 °C | farbloser Feststoff | 1.4400 (A) |
| **182** | alpha-(6- { [(Hexafluorpropan-2-yl) carbonyl] amino} hexyl)-omega-[2,4,6-trioxo-3,5-bis(6-{[(hexafluorpropan-2-yl) carbonyl]amino}hexyl)-1,3,5-triazinan-1-yl]poly{[2,4,6-trioxo-5-(6-{[ (hexafluorpropan-2-yl)carbonyl]amino} hexyl)-1,3,5-triazinan-1,3-diyl]hexan-1,6-diyl} | Desmodur N3600 7.80 g | Hexafluor-2-propanol 7.18 g | Desmorapid Z 0.02 g | 70 °C | farbloser Feststoff | 1.4400 (A) |
| **183** | alpha-(6- { [(Hexafluorpropan-2-yl) carbonyl]amino}hexyl)-omega-{[ (hexafluorpropan-2-yl)-carbonyl]amino} poly({(6Z)-2,4-dioxo-6-[(6-{[ (hexafluorpropan-2-yl)-carbonyl]amino} hexyl)imino]-1,3,5-oxadiazinan-3,5-diyl} hexan-1,6-diyl) | Desmodur N3900 7.76 g | Hexafluor-2-propanol 7.22 g | Desmorapid Z 0.02 g | 70 °C | farbloser Feststoff | 1.4400 (A) |
| **184** | alpha-(6-{[(Hexafluorpropan-2-yl)-carbonyl]amino} hexyl)-omega-{[ (hexafluorpropan-2-yl)-carbonyl]amino} poly[(2,4,6-trioxo-1,3,5-oxadiazinan-3,5-diyl)hexan-1,6-diyl] | Baymicron OXA 8.25 g | Hexafluor-2-propanol 6.73 g | Desmorapid Z 0.02 g | 70 °C | farbloser Feststoff | 1.4400 (A) |
| **185** | Bis(1,1,1,3,3,3-hexafluorpropan-2-yl)-(cyclohexan-1,3-diyldimethandiyl) biscarbamat | 1,3-Bis-(isocyanatomethyl)-cyclohexan 5.49 g | Hexafluor-2-propanol 9.49 g | Desmorapid Z 0.02 g | 70 °C | farbloser Feststoff | 1.4100 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **186** | 2-Ethylhexyl-2,2,3,3-tetrafluorpropyl-hexan-1,6-diylbiscarbamat | Desmodur LD 10.9 g | Tetrafluor-1-propanol 4.12 g | Desmorapid Z 0.02 g | 70 °C | farbloser Feststoff | 1.4468 (B) |
| **187** | alpha-(6-{[(2,2,3,3-Tetrafluorpropyl) carbonyl]-amino}hexyl)-omega- { [ (2,2,3,3-tetrafluorpropyl)-carbonyl]amino} poly[(2,4-dioxo-1,3-diazetidin-1,3-diyl) hexan-1,6-diyl] | Desmodur N3400 8.89 g | Tetrafluor-1-propanol 6.09 g | Desmorapid Z 0.02 g | 70 °C | farbloser Feststoff | 1.4544 (C) |
| **188** | alpha-(6-{[(2,2,3,3-Tetrafluorpropyl) carbonyl] amino} - hexyl)-omega-[2,4,6-trioxo-3,5-bis(6-{[(2,2,3,3-tetrafluorpropyl)carbonyl]amino}-hexyl)-1,3,5-triazinan-1-yl]poly{[2,4,6-trioxo-5-(6-{[(2,2,3,3-tetrafluorpropyl)carbonyl] amino}-hexyl)-1,3,5-triazinan-1,3-diyl] hexan-1,6-diyl} | Desmodur N3600 8.70 g | Tetrafluor-1-propanol 6.28 g | Desmorapid Z 0.02 g | 70 °C | farbloser Feststoff | 1.4580 (C) |
| **189** | alpha-(6-{[(2,2,3,3-Tetrafluorpropyl) carbonyl]amino}-hexyl)-omega- {[ (2,2,3,3-tetrafluorpropyl)-carbonyl]amino} poly({(6Z)-2,4-dioxo-6-[(6-{[(2,2,3,3-tetrafluorpropyl)-carbonyl]amino{hexyl) imino]-1,3,5-oxadiazinan-3,5-diyl}hexan-1,6-diyl) | Desmodur N3900 8.65 g | Tetrafluor-1-propanol 6.33 g | Desmorapid Z 0.02 g | 70 °C | farbloser Feststoff | 1.4588 (C) |
| **190** | alpha-(6- {[(2,2,3,3-Tetrafluorpropyl)-carbonyl]amino} hexyl)-omega-{[(2,2,3,3-tetrafluorpropyl)-carbonyl]amino} poly[(2,4,6-trioxo-1,3,5-oxadiazinan-3,5-diyl)hexan-1,6-diyl] | Baymicron OXA 9.13 g | Tetrafluor-1-propanol 5.85 g | Desmorapid Z 0.02 g | 70 °C | farbloser Feststoff | 1.4590 (C) |
| **191** | Bis(2,2,3,3-Tetrafluorpropyl)-(cyclohexan-1,3-diyldimethandiyl)biscarbamat | 1,3-Bis-(isocyanatomethyl)-cyclohexan 6.35 g | Tetrafluor-1-propanol 8.63 g | Desmorapid Z 0.02 g | 70 °C | farbloser Feststoff | 1.4300 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **192** | 2-Ethylhexyl-2,2,3,3,4,4,5,5,5-nonafluorpentyl-hexan-1,6-diylbiscarbamat | Desmodur LD 8.71 g | 2,2,3,3,4,4,5,5,5-Nonafluorpentan-1-ol 6.27 g | Desmorapid Z 0.02 g | 70 °C | farbloser Feststoff | 1.4200 (A) |
| **193** | alpha-(6-{[(2,2,3,3,4,4,5,5,5-nonafluorpentan-1-oxy)carbonyl]-amino}hexyl)-omega-{[(2,2,3,3,4,4,5,5,5-nonafluorpentan-1-oxy)carbonyl]amino}poly[(2,4-dioxo-1,3-diazetidin-1,3-diyl)hexan-1,6-diyl] | Desmodur N3400 6.52 g | 2,2,3,3,4,4,5,5,5-Nonafluorpentan-1-ol 8.46 g | Desmorapid Z 0.02 g | 70 °C | farbloser Feststoff | 1.4200 (A) |
| **194** | alpha-(6-{[(2,2,3,3,4,4,5,5,5-nonafluorpentan-1-oxy)carbonyl]-amino}hexyl)-omega-[2,4,6-trioxo-3,5-bis(6-{[(2,2,3,3,4,4,5,5,5-nonafluorpentan-1-oxy)carbonyl]-amino}hexyl)-1,3,5-triazinan-1-yl]poly{[2,4,6-trioxo-5-(6-{[(2,2,3,3,4,4,5,5,5-nonafluorpentan-1-oxy)carbonyl]amino}hexyl)-1,3,5-triazinan-1,3-diyl]hexan-1,6-diyl} | Desmodur N3600 6.32 g | 2,2,3,3,4,4,5,5,5-Nonafluorpentan-1-ol 8.66 g | Desmorapid Z 0.02 g | 70 °C | farbloser Feststoff | 1.4232 (C) |
| **195** | alpha-(6-{[(2,2,3,3,4,4,5,5,5-nonafluorpentan-1-oxy)carbonyl]-amino}hexyl)-omega-{[(2,2,3,3,4,4,5,5,5-nonafluorpentan-1-oxy)carbonyl]amino}poly({(6Z)-2,4-dioxo-6-[(6-{[(2,2,3,3,4,4,5,5,5-nonafluorpentan-1-oxy)carbonyl]-amino} hexyl)imino]-1,3,5-oxadiazinan-3,5-diyl}hexan-1,6-diyl) | Desmodur N3900 6.28 g | 2,2,3,3,4,4,5,5,5-Nonafluorpentan-1-ol 8.70 g | Desmorapid Z 0.02 g | 70 °C | farbloser Feststoff | 1.4195 (B) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **196** | alpha-(6-{[(2,2,3,3,4,4,5,5,5-nonafluorpentan-1-oxy)carbonyl]-amino}hexyl)-omega-{[(2,2,3,3,4,4,5,5,5-nonafluorpentan-1-oxy)carbonyl]amino}poly[(2,4,6-trioxo-1,3,5-oxadiazinan-3,5-diyl)hexan-1,6-diyl] | Baymicron OXA 6.77 g | 2,2,3,3,4,4,5,5,5-Nonafluorpentan-1-ol 8.21 g | Desmorapid Z 0.02 g | 70 °C | farbloser Feststoff | 1.4216 (C) |
| **197** | Bis(2,2,3,3,4,4,5,5,5-nonafluorpentyl)-(cyclohexan-1,3-diyldimethandiyl)biscarbamat | 1,3-Bis-(isocyanatomethyl)-cyclohexan 4.19 g | 2,2,3,3,4,4,5,5,5-Nonafluorpentan-1-ol 10.8 g | Desmorapid Z 0.02 g | 70 °C | farbloser Feststoff | 1.4012 (C) |
| **198** | 2,2,3,3,4,4,5,5,6,6,7,7-Dodecafluorheptyl-2-ethylhexyl-hexan-1,6-diylbiscarbamat | Desmodur LD 7.66 g | 2,2,3,3,4,4,5,5,6,6,7,7-Dodecafluorheptan-1-ol 7.32 g | Desmorapid Z 0.02 g | 70 °C | farbloser Feststoff | 1.4096 (B) |
| **199** | alpha-(6-{[(2,2,3,3,4,4,5,5,6,6,7,7-Dodecafluorheptan-1-oxy) carbonyl]-amino}hexyl)-omega-{[(2,2,3,3,4,4,5,5,6,6,7,7-Dodecafluorheptan 1-oxy)-carbonyl] amino}poly[(2,4-dioxo-1,3-diazetidin-1,3-diyl)hexan-1,6-diyl] | Desmodur N3400 5.50 g | 2,2,3,3,4,4,5,5,6,6,7,7-Dodecafluorheptan-1-ol 9.48 g | Desmorapid Z 0.02 g | 70 °C | farbloser Feststoff | 1.4126 (C) |
| **200** | alpha-(6-{[(2,2,3,3,4,4,5,5,6,6,7,7-Dodecafluorheptan 1-oxy) carbonyl]-amino}hexyl)-omega-[2,4,6-trioxo-3,5-bis(6-{[(2,2,3,3,4,4,5,5,6,6,7,7-Dodecafluorheptan-1-oxy)car-bonyl] amino}hexyl)-1,3,5-triazinan-1-yl] poly{[2,4,6-trioxo-5-(6-{[(2,2,3,3,4,4,5,5,6,6,7,7-Dodecafluorheptan-1-oxy)carbonyl] amino} hexyl)-1,3,5-triazinan-1,3-diyl] hexan-1,6-diyl} | Desmodur N3600 5.32 g | 2,2,3,3,4,4,5,5,6,6,7,7-Dodecafluorheptan-1-ol 9.67 g | Desmorapid Z 0.02 g | 70°C | farbloser Feststoff | 1.430 (A) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **201** | alpha-(6-{[(2,2,3,3,4,4,5,5,6,6,7,7-Dodecafluorheptan-1-oxy) carbonyl]-amino}hexyl)-omega-{[(2,2,3,3,4,4,5,5,6,6,7,7-Dodecafluorheptan 1-oxy)-carbonyl] amino}poly({(6Z)-2,4-dioxo-6-[(6-{[(2,2,3,3,4,4,5,5,6,6,7,7-Dodecafluorheptan-1-oxy) carbonyl]-amino}hexyl)imino]-1,3,5-oxadiazinan-3,5-diyl}hexan-1,6-diyl) | Desmodur N3900 5.27 g | 2,2,3,3,4,4,5,5,6,6,7,7-Dodecafluorheptan-1-ol 9.71 g | Desmorapid Z 0.02 g | 70°C . | farbloser Feststoff | 1.410 (A) |
| **202** | alpha-(6-{[(2,2,3,3,4,4,5,5,6,6,7,7-Dodecafluorheptan 1-oxy) carbonyl]-amino}hexyl)-omega-{[(2,2,3,3,4,4,5,5,6,6,7,7-Dodecafluorheptan-1-oxy)-carbonyl] amino}poly[(2,4,6-trioxo-1,3,5-oxadiazinan-3,5-diyl)hexan-1,6-diyl] | Baymicron OXA 5.73 g | 2,2,3,3,4,4,5,5,6,6,7,7-Dodecafluorheptan-1-ol 9.25 g | Desmorapid Z 0.02 g | 70 °C | farbloser Feststoff | 1.4100 (A) |
| **203** | Bis(2,2,3,3,4,4,5,5,6,6,7,7-dodecafluorheptyl)-(cyclohexan-1,3-diyldimethandiyl)biscarbamat | 1,3-Bis-(isocyanatomethyl)-cyclohexan 3.39 g | 2,2,3,3,4,4,5,5,6,6,7,7-Dodecafluorheptan-1-ol 11.6 g | Desmorapid Z 0.02 g | 70 °C | farbloser Feststoff | 1.4020 (A) |
| **204** | 2-Ethylhexyl-2,2,3,3,4,4,5,5,6,6,7,7,8,8,8-penta-decafluoroctyl-hexan-1,6-diylbiscarbamat | Desmodur LD 6.96 g | 2,2,3,3,4,4,5,5,6,6,7,7,8,8,8-Pentadecafluor-octan-1-ol 8.02 g | Desmorapid Z 0.02 g | 70 °C | farbloser Feststoff | 1.4262 (C) |
| **205** | alpha-(6-{[(2,2,3,3,4,4,5,5,6,6,7,7,8,8,8-Pentadecafluoroctan-1-oxy) carbonyl]-amino}hexyl)-omega-{[(12,2,3,3,4,4,5,5,6,6,7,7,8,8,8-Pentadecafluoroctan-1-oxy)-carbonyl] amino}poly[(2,4-dioxo-1,3-diazetidin-1,3-diyl)hexan-1,6-diyl] | Desmodur N3400 4.87 g | 2,2,3,3,4,4,5,5,6,6,7,7,8,8,8-Pentadecafluor-octan-1-ol 10.1 g | Desmorapid Z 0.02 g | 70 °C | farbloser Feststoff | 1.4032 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **206** | alpha-(6-{[(2,2,3,3,4,4,5,5,6,6,7,7,8,8,8-Pentadecafluoroctan-1-oxy) carbonyl]-amino}hexyl)-omega-[2,4,6-trioxo-3,5-bis(6-{[ (2,2,3,3,4,4,5,5,6,6,7,7,8,8,8-Pentadecafluoroctan-1-oxy)carbonyl] amino}hexyl)-1,3,5-triazinan-1-yl] poly{[2,4,6-trioxo-5-(6-{[ (12,2,3,3,4,4,5,5,6,6,7,7,8,8,8-Pentadecafluoroctan-1-oxy) carbonyl]-amino}hexyl)-1,3,5-triazinan-1,3-diyl]hexan-1,6-diyl} | Desmodur N3600 4.70 g | 2,2,3,3,4,4,5,5,6,6,7,7,8 ,8,8-Pentadecafluor-octan-1-ol 10.3 g | Desmorapid Z 0.02 g | 70 °C | farbloser Feststoff | 1.4074 (C) |
| **207** | alpha-(6-{[(2,2,3,3,4,4,5,5,6,6,7,7,8,8,8-Pentadecafluoroctan-1-oxy) carbonyl]-amino}hexyl)-omega-{[ (2,2,3,3,4,4,5,5,6,6,7,7,8,8,8-Pentadecafluoroctan-1-oxy)-carbonyl] amino}poly({(6Z)-2,4-dioxo-6-[(6-{[ (2,2,3,3,4,4,5,5,6,6,7,7,8,8,8-Pentadecafluoroctan-1-oxy) carbonyl]-amino}hexyl)imino]-1,3,5-oxadiazinan-3,5-diyl}hexan-1,6-diyl) | Desmodur N3900 4.65 g | 2,2,3,3,4,4,5,5,6,6,7,7,8 ,8,8-Pentadecafluor-octan-1-ol 10.3 g | Desmorapid Z 0.02 g | 70 °C | farbloser Feststoff | 1.4058 (C) |
| **208** | alpha-(6-{[(2,2,3,3,4,4,5,5,6,6,7,7,8,8,8-Pentadecafluoroctan-1-oxy) carbonyl]-amino}hexyl)-omega-{[ (2,2,3,3,4,4,5,5,6,6,7,7,8,8,8-Pentadecafluoroctan-1-oxy)-carbonyl] amino}poly[(2,4,6-trioxo-1,3,5-oxadiazinan-3,5-diyl)hexan-1,6-diyl] | Baymicron OXA 5.09 g | 2,2,3,3,4,4,5,5,6,6,7,7,8 ,8,8-Pentadecafluor-octan-1-ol 9.89 g | Desmorapid Z 0.02 g | 70 °C | farbloser Feststoff | n.b. |
| **209** | Bis(2,2,3,3,4,4,5,5,6,6,7,7,8,8,8-pentadecafluoroctyl)-(cyclohexan-1,3-diyldimethandiyl)biscarbamat | 1,3-Bis-(isocyanatomethyl)-cyclohexan 2.93 g | 2,2,3,3,4,4,5,5,6,6,7,7,8 ,8,8-Pentadecafluor-octan-1-ol 12.1 g | Desmorapid Z 0.02 g | 70 °C | farbloser Feststoff | 1.3862 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **210** | Butyl-(3,3,4,4,5,5,6,6,7,7,8,8,9,9,10,10,10-heptadecafluordecyl)carbamat | 3,3,4,4,5,5,6,6,7,7,8 Heptadecafluordecylisocyanat 1.52 g | n-Butanol 0.23 g | Desmorapid Z 0.001 g | 70 °C | | n.b. |
| **211** | Isopropyl-(3,3,4,4,5,5,6,6,7,7,8,8,9,9,10,10,10-heptadecafluordecyl)carbamat | 3,3,4,4,5,5,6,6,7,7,8 , 8,9,9,10,10,10-Heptadecafluordecylisocyanat 1.52 g | i-Propanol 0.23 g | Desmorapid Z 0.001 g | 70 °C | | n.b. |
| **212** | 1,1,1,3,3,3-Hexafluorpropan-2-yl-(3,3,4,4,5,5,6,6,7,7,8,8,9,9,10,10,10-heptadecafluordecyl)carbamat | 3,3,4,4,5,5,6,6,7,7,8 , 8,9,9,10,10,10-Heptadecafluordecylisocyanat 1.12 g | Hexafluor-2-propanol 0.38 g | Desmorapid Z 0.001 g | 70 °C | | n.b. |
| **213** | 2,2,2-Trifluorethyl-phenylcarbamat | Phenylisocyanat 81.5 g | Trifluorethanol 68.4 g | Desmorapid Z 0.07 g | 60 °C | farbloser Feststoff | 1.4838 (C) |
| **214** | 1,1,1,3,3,3-Hexafluorpropan-2-yl-phenylcarbamat | Phenylisocyanat 8.29 g | Hexafluor-2-propanol 11.7 g | Desmorapid Z 0.01 g | 60 °C | farbloser Feststoff | 1.4476 (C) |
| **215** | 1,1,1,3,3,3-Hexafluorpropan-2-yl-2,2,2-trifluorethyl-hexan-1,6-diylbiscarbamat | 2,2,2-Trifluorethyl-(6-isocyanatohe-xyl)carbamat 5.24 g | Hexafluor-2-propanol 4.75 g | Desmorapid Z 0.01 g | 70 °C | farbloser Feststoff | 1.4280 (C) |
| **216** | 2,2,3,3-Tetrafluorpropyl-2,2,2-trifluorethyl-hexan-1,6-diylbiscarbamat | 2,2,2-Trifluorethyl-(6-iso-cyanatohe-xyl)carbamat 5.83 g | Tetrafluor-1-propanol 4.16 g | Desmorapid Z 0.01 g | 70 °C | farbloser Feststoff | 1.4514 (C) |
| **217** | 2,2,3,3,4,4,5,5,5-Nonafluorpentyl-2,2,2-trifluorethyl-hexan-1,6-diylbiscarbamat | 2,2,2-Trifluorethyl-(6-iso-cyanatohe-xyl)carbamat 4.25 g | 2,2,3,3,4,4,5,5,5-Nonafluorpentan-1-ol 5.74 | Desmorapid Z 0.01 g | 70 °C | farbloser Feststoff | 1.4168 (C) |
| **218** | 2,2,3,3,4,4,5,5,6,6,7,7-Dodecafluorheptyl-2,2,2-trifluorethyl-hexan-1,6-diylbiscarbamat | 2,2,2-Trifluorethyl-(6-iso-cyanatohe-xyl)carbamat 3.57 g | 2,2,3,3,4,4,5,5,6,6,7,7-Dodecafluorheptan-1-ol 5.74 g | Desmorapid Z 0.01 g | 70 °C | farbloser Feststoff | 1.4172 (C) |
| **219** | 2,2,3,3,4,4,5,5,6,6,7,7,8,8,8-Pentadecafluoroctyl-2,2,2-trifluorethyl-hexan-1,6-diylbiscarbamat | 2,2,2-Trifluorethyl-(6-iso-cyanatohe-xyl)carbamat 3.16 g | 2,2,3,3,4,4,5,5,6,6,7,7,8 ,8,8-Pentadecafluor-octan-1-ol 6.83 g | Desmorapid Z 0.01 g | 70 °C | farbloser Feststoff | n.b. |
| **220** | 2,2,3,3,4,4,5,5-Octafluorpentyl-2,2,2-trifluorethyl-hexan-1,6-diylbiscarbamat | 2,2,3,3,4,4,5,5-Octafluorpentyl-(6-isocyanatohexyl)-carbamat 7.68 g | Trifluorethanol 2.3 1 g | Desmorapid Z 0.01 g | 70 °C | farbloser Feststoff | 1.4236 (C) |

(fortgesetzt)

| Beispiel | Name | Isocyanat und Menge | Alkohol und Menge | Katalysator und Menge | Temp [°C] | Beschreibung | Brechungsindex (Methode) |
|---|---|---|---|---|---|---|---|
| **221** | 1,1,1,3,3,3-Hexafluorpropan-2-yl-2,2,3,3,4,4,5,5-octafluorpentyl-hexan-1,6-diylbiscarbamat | 2,2,3,3,4,4,5,5-Octafluorpentyl-(6-isocyanatohexyl)-carbamat 6.64 g | Hexafluor-2-propanol 3.35 g | Desmorapid Z 0.01 g | 70 °C | farbloses Öl | 1.4086 (C) |
| **222** | 2,2,3,3,4,4,5,5-Octafluorpentyl-2,2,3,3-tetrafluorpropyl-hexan-1,6-diylbiscarbamat | 2,2,3,3,4,4,5,5-Octafluorpentyl-(6-isocyanatohexyl)-carbamat 7.15 g | Tetrafluor-1-propanol 2.84 g | Desmorapid Z 0.01 g | 70 °C | farbloser Feststoff | 1.4256 (C) |
| **223** | 2,2,3,3,4,4,5,5,6,6,7,7-Dodecafluorheptyl-2,2,3,3,4,4,5,5-octafluorpentyl-hexan-1,6-diylbiscarbamat | 2,2,3,3,4,4,5,5-Octafluorpentyl-(6-isocyanatohexyl)-carbamat 5.00 g | 2,2,3,3,4,4,5,5,6,6,7,7-Dodecafluorheptan-1-ol 4.99 Dodecafluorheptan- g 4.99 g | Desmorapid Z 0.01 g | 70 °C | farbloses Öl | 1.4048 (C) |
| **224** | 2,2,3,3,4,4,5,5-Octafluorpentyl-2,2,3,3,4,4,5,5,6,6,7,7,8,8,8-pentadecafluoroctyl-hexan-1,6-diylbiscarbamat | 2,2,3,3,4,4,5,5-Octafluorpentyl-(6-isocyanatohexyl)-carbamat 4.54 g | 2,2,3,3,4,4,5,5,6,6,7,7,8,8,8-Pentadecafluor-octan-1-ol 5.45 g | Desmorapid Z 0.01 g | 70 °C | farbloser Feststoff | 1.3970 (C) |

**Beispiel 225: 9,9,10,10,11,11,12,12,13,13,14,14,29,29,30,30,31,31,32,32, 33,33,34,34-Tetracosafluor-20,20,22-trimethyl-6,17,26-trioxo-7,16,27-trioxa-5,18,25-triazapentatriacontan-35-yl-butylcarbamat**

In einem 250 mL Rundkolben wurde 2,2,3,3,4,4,5,5,6,6,7,7-Dodecafluor-1,8-octandiol vorgelegt und 0.05 g Dibutylzinndilaurat (Desmorapid Z, Bayer MaterialScience AG, Leverkusen, Deutschland) zugegeben und auf 60 °C erwärmt. Es wurden 18.7 g n-Butylisocyanat portionsweise hinzugegeben und für 3 h bei 60 °C nachgerührt. Anschließend wurden 19.9 g 2,4,4-Trimethylhexane-1,6-diisocyanat (TMDI) zugetropft und die Mischung weiter auf 60 °C gehalten, bis der Isocyanatgehalt unter 0.1 % gesunken war. Danach wurde abgekühlt und das Produkt wurde als farbloses Öl erhalten, der nach Methode B bestimmte Brechungsindex ist $n_D^{20} = 1.4131$.

**Beispiel 226: 23-(8,8,9,9,10,10,11,11,12,12,13,13-Dodecafluor-5,16-dioxo-6,15-dioxa-4,17-diazahenicos-1-yl)-9,9,10,10,11,11,12,12,13,13,14,14,29,29,30,30,31, 31,32,32,33,33,34,34-tetracosafluor-6,17,26-trioxo-7,16,27-trioxa-5,18,25-triaza-pentatriacontan-35-yl-butylcarbamat**

In einem 100 mL Rundkolben wurde 2,2,3,3,4,4,5,5,6,6,7,7-Dodecafluor-1,8-octandiol vorgelegt und 0.01 g Dibutylzinndilaurat (Desmorapid Z, Bayer MaterialScience AG, Leverkusen, Deutschland) zugegeben und auf 60 °C erwärmt. Es wurden 3.63 g n-Butylisocyanat porti-onsweise hinzugegeben und für 3 h bei 60 °C nachgerührt. Anschließend wurden 3.08 g 1,8-Diisocyanato-4-(isocyanatomethyl)octan (TIN) zugetropft und die Mischung weiter auf 60°C gehalten, bis der Isocyanatgehalt unter 0.1 % gesunken war. Danach wurde abgekühlt und das Produkt wurde als farbloses Öl erhalten, der nach Methode A bestimmte Brechungsindex ist n = 1.4200.

<u>**Herstellung der Medien**</u>

Zur Prüfung der optischen Eigenschaften wurden wie im Folgenden beschrieben Medien hergestellt und optisch vermessen:

**Herstellung der Polyol-Komponente:**

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Herstellung des Urethanacrylats 1: Phosphorothioyltris(oxybenzol-4,1-diylcarbamoyloxyethan-2,1-diyl)trisacrylat**

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) sowie und 213.07 g einer 27 %-igen Lösung von Tris (p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

**Herstellung des Urethanacrylats 2: 2-({[3-(Methylsulfanyl)phenyl]carbamoyl}oxy)-propylprop-2-enoat**

In einem 250 mL Rundkolben wurden 0.05 g 2,6-Di-tert.-butyl-4-methylphenol, 0.02 g Desmorapid Z, 26.8 g 3-(Methylthio)phenylisocyanat in 50 g Ethylacetat vorgelegt und auf 60 °C erwärmt. Anschließend wurden 21.1 g 2-Hydroxypropylacrylat zugetropft und die Mischung weiter auf 60 °C gehalten, bis der Isocyanatgehalt unter 0.1 % gesunken war. Danach wurde das Ethylacetat bei 5 mbar abdestilliert und abgekühlt. Das Produkt wurde als hellgelbe Flüssigkeit erhalten.

**Medium 1:**

3.82 g der wie oben beschrieben hergestellten Polyol-Komponente wurden mit 2.50 g Phosphorothioyltris (oxybenzol-4,1-diylcarbamoyl-oxyethan-2,1-diyl)trisacrylat (Urethan-acrylat 1), 2.50 g 2,2,2-Trifluorethyl-hexylcarbamat (Beispiel 4), 0.10 g CGI 909 (Versuchsprodukt der Fa. Ciba Inc, Basel, Schweiz), 0.01 g Neu Methylenblau und 0.35 g N-Ethylpyrrolidon bei 60 °C gemischt, so dass eine klare Lösung erhalten wurde. Anschließend wurde auf 30 °C abgekühlt,

0.71 g Desmodur® N3900 (Handelsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %) zugegeben und erneut gemischt. Schließlich wurden 0.006 g Fomrez UL 28 (Urethanisierungskatalysator, Handelsprodukt der Fa.

Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

Die Medien 2-13 wurden in analoger Art und Weise aus den in Tabelle 1 aufgeführten Beispielen hergestellt. Dabei ist jeweils in der Tabelle 2 angegeben, welche Beispielverbindung mit welchem Gehalt in der Photopolymer-Pormulierung enthalten war. Die für die hergestellten Photopolymer-Formulierungen ermittelten Δn Werte sind ebenfalls in Tabelle 2 zusammengefasst.

**Medium 14:**

3.40 g der wie oben beschrieben hergestellten Polyol-Komponente wurden mit 2.00 g Phosphorothioyltris (oxybenzol-4,1-diylcarbamoyl¬oxyethan-2,1-diyl)trisacrylat (Urethanacrylat 1), 2.00 g 2-({[3-(Methylsulfanyl)phenyl] ¬carbamoyl}oxy)¬propylprop-2-enoat (Urethanacrylat 2), 1.50 g 2,2,2-Trifluorethyl-hexylcarbamat (Beispiel 4), 0.10 g CGI 909 (Versuchsprodukt der Fa. Ciba Inc, Basel, Schweiz), 0.01 g Neu Methylenblau und 0.35 g N-Ethylpyrrolidon bei 60 °C gemischt, so dass eine klare Lösung erhalten wurde. Anschließend wurde auf 30 °C abgekühlt, 0.64 g N3900 (Handelsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %) zugegeben und erneut gemischt. Schließlich wurden 0.006 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

Die Medien 14-70 wurden in analoger Art und Weise aus den in Tabelle 1 aufgeführten Beispielen hergestellt. Dabei ist jeweils in der Tabelle 3 angegeben, welche Beispielverbindung mit welchem Gehalt in der Photopolymer-Pormulierung enthalten war. Die für die hergestellten Photopolymer-Formulierungen ermittelten Δn Werte sind ebenfalls in Tabelle 3 zusammengefasst.

**Vergleichsmedium I:**

8.89 g der wie oben beschrieben hergestellten Polyol-Komponente wurden mit 3.75 g Phosphorothioyltris (oxybenzol-4,1-diylcarbamoyl¬oxyethan-2,1-diyl)trisacrylat (Urethanacrylat 1), 0.15 g CGI 909 (Versuchsprodukt der Fa. Ciba Inc., Basel, Schweiz), 0.015 g Neu Methylenblau und 0.53 g N-Ethylpyrrolidon bei 60 °C so gemischt, dass eine klare Lösung erhalten wurde. Anschließend wurde auf 30 °C abgekühlt, 1.647 g Desmodur® N 3900 (Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23.5 %) zugegeben und erneut gemischt. Schließlich wurden 0.009 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

**Vergleichsmedium II:**

3.82 g der wie oben beschrieben hergestellten Polyol-Komponente wurden mit 2.50 g Phosphorothioyltris (oxybenzol-4,1-diylcarbamoyl¬oxyethan-2,1-diyl)trisacrylat (Urethan-acrylat 1), 2.50 g Propylencarbonat (Vergleichsbeispiel II), 0.10 g CGI 909 (Versuchsprodukt der Fa. Ciba Inc, Basel, Schweiz), 0.010 g Neu Methylenblau und 0.35 g N-Ethylpyrrolidon bei 60 °C so gemischt, dass eine klare Lösung erhalten wurde. Anschließend wurde auf 30 °C abgekühlt, 0.702 g Desmodur® N 3900 (Handelsprodukt der Bayer MaterialScience AG, Leverkusen, Deutschland, Hexandiisocyanat-basiertes Polyisocyanat, Anteil an Iminooxadiazin-dion mindestens 30 %, NCO-Gehalt: 23.5 %) zugegeben und erneut gemischt. Schließlich wurden 0.022 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

Die Vergleichsmedien III-V wurden in analoger Art und Weise aus den in Tabelle 2 aufgeführten Vergleichsbeispielen hergestellt.

**Vergleichsmedium VI:**

4.66 g der wie oben beschrieben hergestellten Polyol-Komponente wurden mit 2.00 g Phosphorothioyltris (oxybenzol-4,1-diylcarbamoyhoxyethan-2,1-diyl)trisacrylat (Urethanacrylat 1), 2.00 g 2-({[3-(Methylsulfanyl)phenyl] ¬carbamoyl}oxy)¬propylprop-2-enoat (Urethanacrylat 2), 0.10 g CGI 909 (Versuchsprodukt der Fa. Ciba Inc, Basel, Schweiz), 0.010 g Neu Methylenblau und 0.35 g N-Ethylpyrrolidon bei 60 °C so gemischt, dass eine klare Lösung erhalten wurde. Anschließend wurde auf 30 °C abgekühlt, 0.87 g Desmodur® N 3900 (Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23.5 %) zugegeben und erneut gemischt. Schließlich wurden 0.006 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 µm gehalten wurde. Dieser Probenkörper wurde 12 Stunden bei Raumtemperatur liegen gelassen und gehärtet.

Tabelle 2: Holographische Bewertung ausgewählter Beispiele in der Formulierung mit 25% Urethanacrylat 1 und 25 % Additiv (fluoriertes Urethan).

| **Medium** | **Beispiel, [Gew-%]** | Δn |
|---|---|---|
| 1 | **4**,25 | 0.0198 |
| 2 | **2**,25 | 0.0187 |
| 3 | **5**,25 | 0.0235 |
| 4 | **6**,25 | 0.0183 |
| 5 | **9**,25 | 0.0220 |
| 6 | **11**,25 | 0.0210 |
| 7 | **12**,25 | 0.0194 |
| 8 | **14**,25 | 0.0223 |
| 9 | **15**,25 | 0.0150 |
| 10 | **19**,25 | 0.0173 |
| 11 | **20**,25 | 0.0249 |
| 12 | **21**,25 | 0.0257 |
| 13 | **214**,25 | 0.0152 |
| **Medium** | **Vergleichsbeispiele**, **[Gew.-%]** | Δn |
| I | Kein Additiv | 0.0115 |
| II | Propylencarbonat, 25 | 0.0136 |
| III | Adipinsäuredimethylester, 25 | 0.0146 |
| IV | Diethylenglycoldiacetat, 25 | 0.0146 |
| V | Zitronensäuretriethylester, 25 | 0.0115 |

Die beschriebenen Werte für Δn wurden bei Dosen von 4-32 mJ/cm$^2$ erzielt.

Die gefundenen Werte für die holographischen Eigenschaft Δn der holographischen Medien zeigen, dass die in den Vergleichsmedium verwendete kommerziellen Additive für die Verwendung in holographischen Medien weniger geeignet ist, wohingegen die erfindungsgemäßen Urethane in den Medien 1 bis 13 für die Herstellung holographischer Medien aufgrund der höheren Wertes für Δn sehr gut geeignet sind.

Tabelle 3: Holographische Bewertung ausgewählter Beispiele in der Formulierung mit 20 Gew.-% Urethanacrylat 1, 20 Gew.-% Urethanacrylat 2 und 15 Gew.-% Additiv (fluoriertes Urethan).

| **Medium** | **Beispiel, [Gew.-%]** | Δn |
|---|---|---|
| 14 | **2**, 15 | 0.0253 |
| 15 | **4**, 15 | 0.0238 |
| 16 | **5**, 15 | 0.0302 |
| 17 | **7**, 15 | 0.0305 |
| 18 | **8**, 15 | 0.0220 |
| 19 | **14**, 15 | 0.0284 |
| 20 | **15**, 15 | 0.0205 |
| 21 | **19**, 15 | 0.0235 |

(fortgesetzt)

| Medium | Beispiel, [Gew.-%] | Δn |
|---|---|---|
| 22 | **20**, 15 | 0.0310 |
| 23 | **21**, 15 | 0.0330 |
| 24 | **26**, 15 | 0.0365 |
| 25 | **32**, 15 | 0.0348 |
| 26 | **35**, 15 | 0.0295 |
| 27 | **36**, 15 | 0.0217 |
| 28 | **46**, 15 | 0.0261 |
| 29 | **48**, 15 | 0.0261 |
| 30 | **51**, 15 | 0.0230 |
| 31 | **52**, 15 | 0.0310 |
| 32 | **54**, 15 | 0.0310 |
| 33 | **55**, 15 | 0.0245 |
| 34 | **66**, 15 | 0.0250 |
| 35 | **67**, 15 | 0.0260 |
| 36 | **68**, 15 | 0.0250 |
| 37 | **71**, 15 | 0.0230 |
| 38 | **72**, 15 | 0.0234 |
| 39 | **73**, 15 | 0.0240 |
| 40 | **74**, 15 | 0.0260 |
| 41 | **75**, 15 | 0.0225 |
| 42 | **76**, 15 | 0.0204 |
| 43 | **82**, 15 | 0.0239 |
| 44 | **84**, 15 | 0.0203 |
| 45 | **132**, 15 | 0.0286 |
| 46 | **133**, 15 | 0.0283 |
| 47 | **141**, 15 | 0.0239 |
| 48 | **146**, 15 | 0.0210 |
| 49 | **147**, 15 | 0.0272 |
| 50 | **164**, 15 | 0.0220 |
| 51 | **165**, 15 | 0.0229 |
| 52 | **166**, 15 | 0.0209 |
| 53 | **170**, 15 | 0.0235 |
| 54 | **172**, 15 | 0.0245 |
| 55 | **174**, 15 | 0.0202 |
| 56 | **175**, 15 | 0.0201 |
| 57 | **180**, 15 | 0.0230 |
| 58 | **181**, 15 | 0.0235 |
| 59 | **182**, 15 | 0.0255 |
| 60 | **183**, 15 | 0.0248 |
| 61 | **184**, 15 | 0.0233 |
| 62 | **192**, 15 | 0.0261 |
| 63 | **198**, 15 | 0.0269 |
| 64 | **201**, 15 | 0.0210 |
| 65 | **202**, 15 | 0.0262 |
| 66 | **203**, 15 | 0.0305 |
| 67 | 220, 15 | 0.0229 |
| 68 | **221**, 15 | 0.0279 |
| 69 | **222**, 15 | 0.0221 |
| 70 | **223**, 15 | 0.0303 |
| VI | **Vergleichsbeispiel Kein Additiv** | 0.0140 |

Die beschriebenen Werte für Δn wurden bei Dosen von 4-32 $mJ/cm^2$ erzielt.

Die gefundenen Werte für die holographischen Eigenschaft Δn der holographischen Medien zeigen, dass erfindungsgemäßen fluorierten Urethane in den Medien 14 bis 70 aufgrund der hohen Werte für Δn sehr gut für die Herstellung holographischer Medien geeignet sind.

**Patentansprüche**

1. Photopolymer-Formulierung umfassend Matrixpolymere, Schreibmonomere und Photoinitiatoren, **dadurch gekennzeichnet, dass** sie als Weichmacher Fluorurethane enthält.

2. Photopolymer-Formulierung nach Anspruch 1, **dadurch gekennzeichnet, dass** die Fluorurethane wenigstens ein Strukturelement der allgemeinen Formel (I) aufweisen

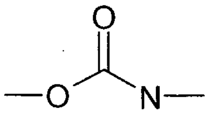

(I)

und mit wenigstens einem Fluoratom substituiert sind.

3. Photopolymer-Formulierung nach einem der Ansprüche 1 oder 2, **dadurch gekennzeichnet, dass** die Fluorurethane die allgemeine Formel (II)

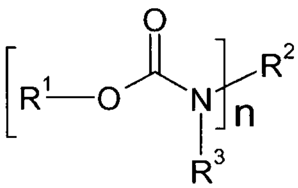

(II)

aufweisen, in der n≥1 und n≤8 ist und $R^1$, $R^2$, $R^3$ Wasserstoff und / oder unabhängig voneinander lineare, verzweigte, cyclische oder heterocyclische unsubstituierte oder gegebenenfalls auch mit Heteroatomen substituierte organische Reste sind, wobei mindestens einer der Reste $R^1$, $R^2$, $R^3$ mit wenigstens einem Fluoratom substituiert ist.

4. Photopolymer-Formulierung nach Anspruch 3, **dadurch gekennzeichnet, dass** $R^1$ ein organischer Rest mit mindestens einem Fluoratom ist.

5. Photopolymer-Formulierung nach Anspruch 3, **dadurch gekennzeichnet, dass** $R^1$ 1-20 $CF_2$ Gruppen und / oder eine oder mehrere $CF_3$ Gruppen, besonders bevorzugt 1-15 $CF_2$ Gruppen und / oder eine oder mehrere $CF_3$ Gruppen, insbesondere bevorzugt 1-10 $CF_2$ Gruppen und / oder eine oder mehrere $CF_3$ Gruppen, ganz besonders bevorzugt 1-8 $CF_2$ Gruppen und / oder eine oder mehrere $CF_3$ Gruppen, $R^2$ einen C1-C20 Alkyl-Rest, bevorzugt einen C1-C15 Alkyl-Rest besonders bevorzugt einen C1-C10 Alkyl-Rest oder Wasserstoff, und / oder $R^3$ einen C1-C20 Alkyl-Rest, bevorzugt einen C1-C15 Alkyl-Rest, besonders bevorzugt einen C1-C10 Alkyl-Rest oder Wasserstoff umfassen.

6. Photopolymer-Formulierung nach einem der Ansprüche 1 bis 5, **dadurch gekennzeichnet, dass** die Fluorurethane Uretdion-, Isocyanurat-, Biuret-, Allophanat-, Polyhamstoff-, Oxadiazadion- und / oder Iminooxadiazindion-Strukturelemente und / oder Mischungen dieser Strukturelemente aufweisen.

7. Photopolymer-Formulierung nach einem der Ansprüche 1 bis 5, **dadurch gekennzeichnet, dass** die Fluorurethane einen Brechungsindex $n_D^{20}$ von ≤ 1.4600, bevorzugt von ≤ 1.4500, besonders bevorzugt von ≤ 1.4400 und insbesondere bevorzugt von ≤ 1.4300 aufweisen.

**8.** Photopolymer-Formulierung nach einem der Ansprüche 1 bis 7, **dadurch gekennzeichnet, dass** die Fluorurethane einen Fluorgehalt von 10-80 Gew.%, bevorzugt von 12.5-75 Gew.%, besonders bevorzugt 15-70 Gew.% und insbesondere bevorzugt von 17.5-65 Gew.% aufweisen.

**9.** Photopolymer-Formulierung nach einem der Ansprüche 1 bis 8, **dadurch gekennzeichnet, dass** die Matrixpolymere Polyurethane sind.

**10.** Photopolymer-Formulierung nach einem der Ansprüche 1 bis 9 **dadurch gekennzeichnet, dass** die Schreibmonomere Acrylate vorzugsweise mit einem Brechungsindex von $n_D^{20} > 1.50$, weiter bevorzugt Urethanacrylate, insbesondere bevorzugt aromatische Urethanacrylate vorzugsweise mit einem Brechungsindex von $n_D^{20} > 1.50$ sind.

**11.** Photopolymer-Formulierung nach einem der Ansprüche 1 bis 10, **dadurch gekennzeichnet, dass** sie 15 bis 79, bevorzugt 30 bis 60 Gew.-% Matrixpolymere, 5 bis 50, bevorzugt 10 bis 40 Gew.-% Schreibmonomere, 1 bis 10, bevorzugt 1 bis 3 Gew.-% Photoinitiatoren und 5 bis 50, bevorzugt 10 bis 40 Gew.-% Fluorurethane und 0 bis 10 Gew.-% weitere Additive enthalten, wobei die Summe der Bestandteile 100 Gew.-% beträgt.

**12.** Verwendung einer Photopolymer-Formulierung nach einem der Ansprüche 1 bis 11 zur Herstellung von optischen Elementen, insbesondere zur Herstellung von holographischen Elementen und Bildern.

**13.** Verfahren zur Belichtung von holographischen Medien aus einer Photopolymer-Formulierung gemäß einem der Ansprüche 1 bis 11, bei dem die Schreibmonomere durch elektromagnetische Strahlung ortsaufgelöst selektiv polymerisiert werden.

**14.** Fluorurethan, erhältlich durch Umsetzung eines Iminooxadiazindione oder Oxadiazadion enthaltenden Polyisocyanates, das wenigstens eine freie Isocyanat Gruppe aufweist, mit einem Alkohol, wobei das Polyisocyanat und/oder der Alkohol mit wenigstens einem Fluoratom substituiert ist.

**15.** Fluorurethane gemäß der allgemeinen Formel (III)

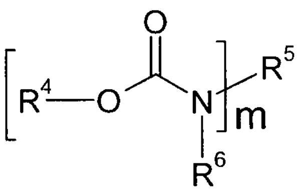

(III)

in der m≥1 und m≤8 ist und $R^4$, $R^5$, $R^6$ Wasserstoff und / oder unabhängig voneinander lineare, verzweigte, cyclische oder heterocyclische unsubstituierte oder gegebenenfalls auch mit Heteroatomen substituierte organische Reste sind und Iminooxadiazindion- und / oder Oxadiazadion-Strukturelemente aufweisen, wobei gleichzeitig wenigstens zwei der Reste $R^4$, $R^5$, $R^6$ mit wenigstens einem Fluoratom substituiert sind.

## Claims

**1.** Photopolymer formulation comprising matrix polymers, writing monomers and photoinitiators, **characterized in that** it comprises fluorourethanes as plasticizers.

**2.** Photopolymer formulation according to Claim 1, **characterized in that** the fluorourethanes have at least one structural element of the general formula (I)

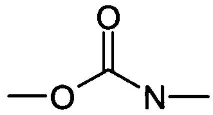
(I)

and are substituted by at least one fluorine atom.

**3.** Photopolymer formulation according to either of Claims 1 and 2, **characterized in that** the fluorourethanes have the general formula (II)

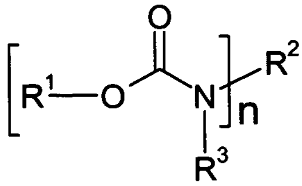
(II)

in which n is ≥ 1 and n is ≤ 8 and $R^1$, $R^2$, $R^3$ are hydrogen and/or, independently of one another, linear, branched, cyclic or heterocyclic organic radicals which are unsubstituted or optionally also substituted by heteroatoms, at least one of the radicals $R^1$, $R^2$, $R^3$ being substituted by at least one fluorine atom.

**4.** Photopolymer formulation according to Claim 3, **characterized in that** $R^1$ is an organic radical having at least one fluorine atom.

**5.** Photopolymer formulation according to Claim 3, **characterized in that** $R^1$ comprises 1-20 $CF_2$ groups and/or one or more $CF_3$ groups, particularly preferably 1-15 $CF_2$ groups and/or one or more $CF_3$ groups, particularly preferably 1-10 $CF_2$ groups and/or one or more $CF_3$ groups, very particularly preferably 1-8 $CF_2$ groups and/or one or more $CF_3$ groups, $R^2$ comprises a C1-C20 alkyl radical, preferably a C1-C15 alkyl radical, particularly preferably a C1-C10 alkyl radical, or hydrogen, and/or $R^3$ comprises a C1-C20 alkyl radical, preferably a C1-C15 alkyl radical, particularly preferably a C1-C10 alkyl radical, or hydrogen.

**6.** Photopolymer formulation according to any of Claims 1 to 5, **characterized in that** the fluorourethanes have uretdione, isocyanurate, biuret, allophanate, polyurea, oxadiazadione and/or iminooxadiazinedione structural elements and/or mixtures of these structural elements.

**7.** Photopolymer formulation according to any of Claims 1 to 5, **characterized in that** the fluorourethanes have a refractive index $n_D^{20}$ of ≤ 1.4600, preferably of ≤ 1.4500, particularly preferably of ≤ 1.4400 and especially preferably of s 1.4300.

**8.** Photopolymer formulation according to any of Claims 1 to 7, **characterized in that** the fluorourethanes have a fluorine content of 10-80% by weight, preferably of 12.5-75% by weight, particularly preferably of 15-70% by weight and especially preferably of 17.5-65% by weight.

**9.** Photopolymer formulation according to any of Claims 1 to 8, **characterized in that** the matrix polymers are polyurethanes.

**10.** Photopolymer formulation according to any of Claims 1 to 9, **characterized in that** the writing monomers are acrylates, preferably having a refractive index of $n_D^{20} > 1.50$, more preferably urethane acrylates, particularly preferably aromatic urethane acrylates, preferably having a refractive index of $n_D^{20} > 1.50$.

**11.** Photopolymer formulation according to any of Claims 1 to 10, **characterized in that** they contain 15 to 79, preferably

30 to 60% by weight of matrix polymers, 5 to 50, preferably 10 to 40% by weight of writing monomers, 1 to 10, preferably 1 to 3% by weight of photoinitiators and 5 to 50, preferably 10 to 40% by weight of fluorourethanes and 0 to 10% by weight of further additives, the sum of the constituents being 100% by weight.

**12.** Use of a photopolymer formulation according to any of Claims 1 to 11 for the production of optical elements, in particular for the production of holographic elements and images.

**13.** Method for exposing holographic media comprising a photopolymer formulation according to any of Claims 1 to 11, in which the writing monomers are selectively polymerized with spatial resolution by electromagnetic radiation.

**14.** Fluorourethane, obtainable by reacting a polyisocyanate which contains iminooxadiazinediones or oxadiazadione and has at least one free isocyanate group with an alcohol, the polyisocyanate and/or the alcohol being substituted by at least one fluorine atom.

**15.** Fluorourethanes according to the general formula (III)

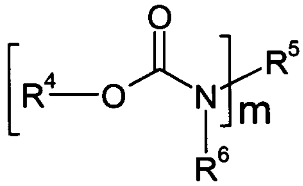

(III)

in which m is ≥ 1 and m is ≤ 8 and $R^4$, $R^5$, $R^6$ are hydrogen and/or, independently of one another, linear, branched, cyclic or heterocyclic organic radicals which are unsubstituted or optionally also substituted by heteroatoms and have iminooxadiazinedione and/or oxadiazadione structural elements, at the same time at least two of the radicals $R^4$, $R^5$, $R^6$ being substituted by at least one fluorine atom.

## Revendications

**1.** Formulation de photopolymère comprenant des polymères de matrice, des monomères d'écriture et des photoinitiateurs, **caractérisée en ce qu'**elle contient des fluoro-uréthanes en tant que plastifiants.

**2.** Formulation de photopolymère selon la revendication 1, **caractérisée en ce que** les fluoro-uréthanes comprennent au moins un élément structural de formule générale (I)

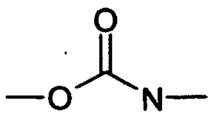

(I)

et sont substitués avec au moins un atome de fluor.

**3.** Formulation de photopolymère selon l'une quelconque des revendications 1 ou 2, **caractérisée en ce que** les fluoro-uréthanes présentent la formule générale (II)

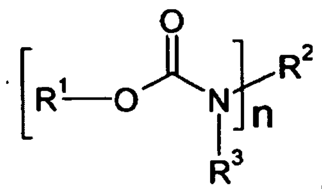

(II)

dans laquelle n ≥ 1 et n ≤ 8, et $R^1$, $R^2$, $R^3$ représentent l'hydrogène et/ou indépendamment les uns des autres des

radicaux organiques linéaires, ramifiés, cycliques ou hétérocycliques non substitués ou éventuellement également substitués avec des hétéroatomes, au moins un des radicaux $R^1$, $R^2$, $R^3$ étant substitué avec au moins un atome de fluor.

**4.** Formulation de photopolymère selon la revendication 3, **caractérisée en ce que** $R^1$ est un radical organique contenant au moins un atome de fluor.

**5.** Formulation de photopolymère selon la revendication 3, **caractérisée en ce que** $R^1$ comprend 1 à 20 groupes $CF_2$ et/ou un ou plusieurs groupes $CF_3$, de manière particulièrement préférée 1 à 15 groupes $CF_2$ et/ou un ou plusieurs groupes $CF_3$, de manière notamment préférée 1 à 10 groupes $CF_2$ et/ou un ou plusieurs groupes $CF_3$, de manière tout particulièrement préférée 1 à 8 groupes $CF_2$ et/ou un ou plusieurs groupes $CF_3$, $R^2$ comprend un radical alkyle en C1-C20, de préférence un radical alkyle en C1-C15, de manière particulièrement préférée un radical alkyle en C1-C10 ou de l'hydrogène, et/ou $R^3$ comprend un radical alkyle en C1-C20, de préférence un radical alkyle en C1-C15, de manière particulièrement préférée un radical alkyle en C1-C10 ou de l'hydrogène.

**6.** Formulation de photopolymère selon l'une quelconque des revendications 1 à 5, **caractérisée en ce que** les fluoro-uréthanes comprennent des éléments structuraux uretdione, isocyanurate, biuret, allophanate, polyurée, oxadiazadione et/ou iminooxadiazinedione et/ou des mélanges de ces éléments structuraux.

**7.** Formulation de photopolymère selon l'une quelconque des revendications 1 à 5, **caractérisée en ce que** les fluoro-uréthanes présentent un indice de réfraction $n_D^{20} \leq 1,4600,$ de préférence ≤ 1,4500, de manière particulièrement préférée ≤ 1,4400 et de manière notamment préférée ≤ 1,4300.

**8.** Formulation de photopolymère selon l'une quelconque des revendications 1 à 7, **caractérisée en ce que** les fluoro-uréthanes présentent une teneur en fluor de 10 à 80 % en poids, de préférence de 12,5 à 75 % en poids, de manière particulièrement préférée de 15 à 70 % en poids et de manière notamment préférée de 17,5 à 65 % en poids.

**9.** Formulation de photopolymère selon l'une quelconque des revendications 1 à 8, **caractérisée en ce que** les polymères de matrice sont des polyuréthanes.

**10.** Formulation de photopolymère selon l'une quelconque des revendications 1 à 9, **caractérisée en ce que** les monomères d'écriture sont des acrylates présentant de préférence un indice de réfraction $n_D^{20} > 1,50,$ de manière davantage préférée des acrylates d'uréthane, de manière notamment préférée des acrylates d'uréthane aromatiques présentant de préférence un indice de réfraction $n_D^{20} > 1,50.$

**11.** Formulation de photopolymère selon l'une quelconque des revendications 1 à 10, **caractérisée en ce qu'**elle contient 15 à 79, de préférence 30 à 60 % en poids de polymères de matrice, 5 à 50, de préférence 10 à 40 % en poids de monomères d'écriture, 1 à 10, de préférence 1 à 3 % en poids de photoinitiateurs et 5 à 50, de préférence 10 à 40 % en poids de fluoro-uréthanes et 0 à 10 % en poids d'autres additifs, la somme des constituants étant de 100 % en poids.

**12.** Utilisation d'une formulation de photopolymère selon l'une quelconque des revendications 1 à 11 pour la fabrication d'éléments optiques, notamment pour la fabrication d'éléments holographiques et d'images.

**13.** Procédé d'exposition de matériaux holographiques constitués d'une formulation de photopolymère selon l'une quelconque des revendications 1 à 11, selon lequel les monomères d'écriture sont polymérisés sélectivement par résolution spatiale par un rayonnement électromagnétique.

**14.** Fluoro-uréthane, pouvant être obtenu par mise en réaction d'un polyisocyanate contenant une iminooxadiazinedione ou une oxadiazadione, qui comprend au moins un groupe isocyanate libre, avec un alcool, le polyisocyanate et/ou l'alcool étant substitués avec au moins un atome de fluor.

**15.** Fluoro-uréthanes de formule générale (III)

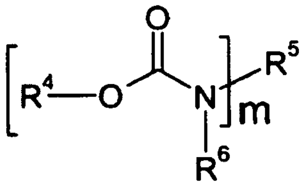

(III)

dans laquelle $m \geq 1$ et $m \leq 8$ et $R^4$, $R^5$, $R^6$ représentent l'hydrogène et/ou indépendamment les uns des autres des radicaux organiques linéaires, ramifiés, cycliques ou hétérocycliques, non substitués ou éventuellement également substitués avec des hétéroatomes, et comprennent des éléments structuraux iminooxadiazinedione et/ou oxadiazadione, au moins deux des radicaux $R^4$, $R^5$, $R^6$ étant substitués simultanément avec au moins un atome de fluor.

Figur 1:

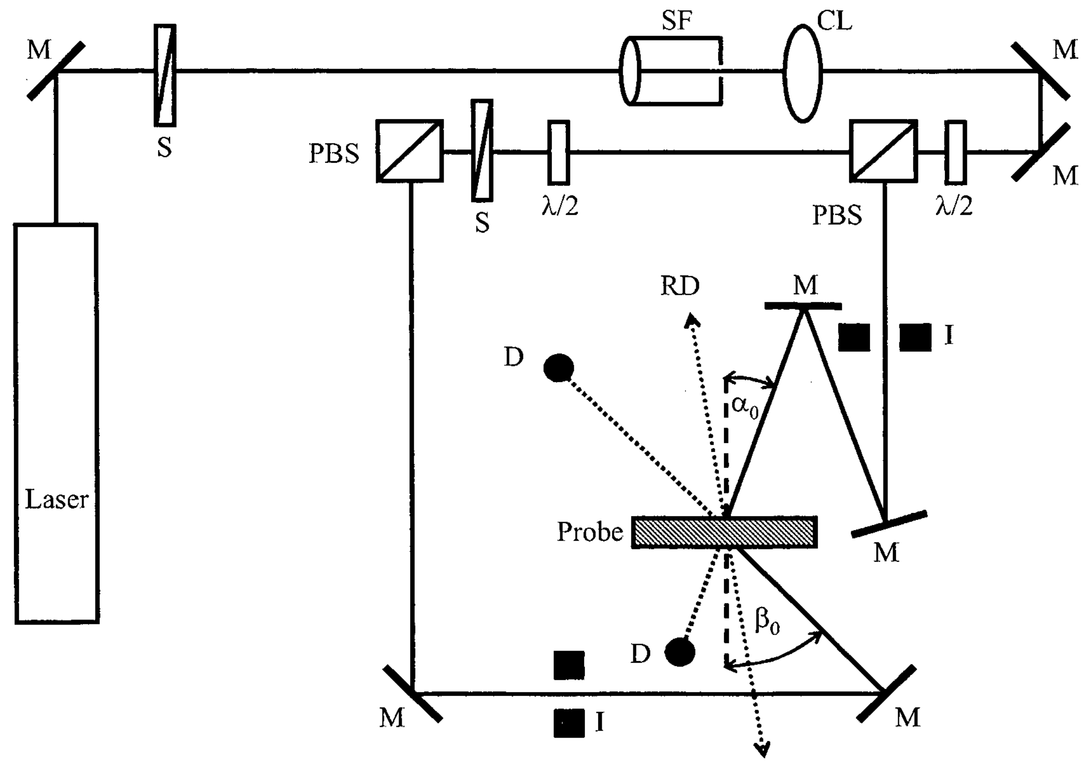


Figur 2:

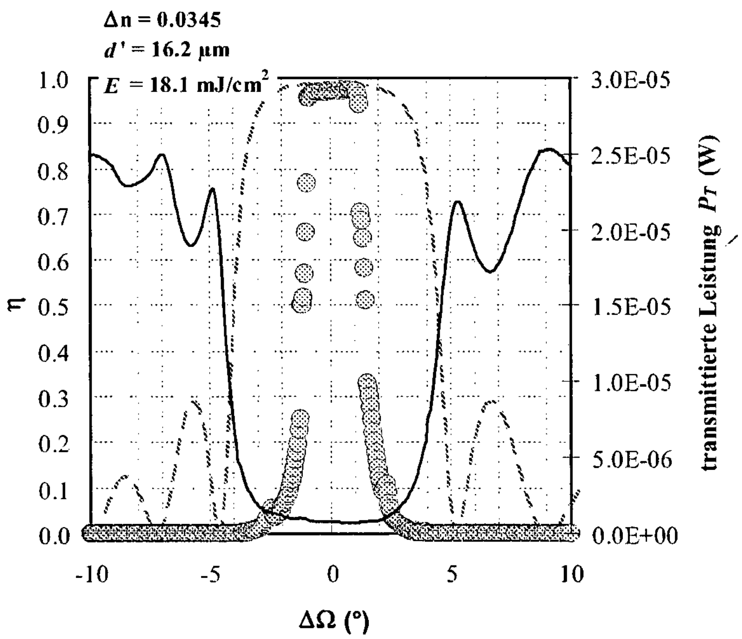

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- EP 0223587 A
- US 6780546 B
- WO 2008125199 A
- US 2003105263 A1
- WO 03023519 A
- EP 749958 A


### In der Beschreibung aufgeführte Nicht-Patentliteratur


- **P. HARIHARAN.** Optical Holography. Cambridge University Press, 1996
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- Chemistry & Technology of UV & EB Formulations For Coatings. Inks & Paints. SITA Technology, 1991, vol. 3, 61-328
- **H. KOGELNIK.** *The Bell System Technical Journal,* 1969, vol. 48 (9), 2909, 2947